# EUROPEAN PATENT SPECIFICATION

(11) **EP 1 840 656 B1**
(45) Date of publication and mention of the grant of the patent: **19.08.2009**
(21) Application number: 07006534.7
(22) Date of filing: 29.03.2007
(51) Int. Cl.: G03F 7/11, B41C 1/10, B41M 5/36

(54) **Polymerizable negative planographic printing plate precursor, stack of planographic printing plate precursors, and method of producing polymerizable negative planographic printing plate precursor**
Polymerisierbarer, negativer, planographischer Druckplattenvorläufer, Stapel von polymerisierbaren, negativen, planographischen Druckplattenvorläufern und Verfahren zur Herstellung eines polymerisierbaren, negativen, planographischen Druckplattenvorläufers
Précurseur de plaque d'impression planographique négative polymérisable, empilement de précurseurs de plaques d'impression planographique, et procédé de production d'un précurseur de plaque d'impression planographique négative polymérisable

(30) Priority: 31.03.2006 JP 2006100505
(43) Date of publication of application: 03.10.2007
(73) Proprietor: FUJIFILM Corporation, Minato-ku Tokyo (JP)
(72) Inventor: Koizumi, Shigeo, Haibara-gun Shizuoka-ken (JP)
(74) Representative: HOFFMANN EITLE

(56) References cited:
- EP-A- 1 629 975
- EP-A- 1 630 611
- EP-A- 1 640 805
- DE-A- 19 639 897

## Description

### Background of the Invention

### Field of the Invention

The invention relates to a negative planographic printing plate precursor allowing high-speed printing and direct platemaking with an infrared laser beam, a stack thereof, and a method of producing the same.

### Description of the Related Art

PS plates having an oleophilic photosensitive resin layer formed on a hydrophilic support have hitherto been widely used as planographic printing plate precursors, and have been commonly produced by mask exposure (surface exposure) through a lith film and dissolving and thus removing the non-image regions. In recent years, digital technology, by which image information is processed, stored, and outputted electronically by computer, is becoming more and more popular. Accordingly, various new image-output methods applicable for this digital technology have come into practical use. As a result, there is an urgent need for "computer to plate (CTP) technology" that allows direct production of printing plates by scanning a high-directivity light such as a laser beam according to digitalized image information without using the lith film, and thus, obtaining planographic printing plate precursors that are applicable for the CTP technology is an important technical issue.

As a planographic printing plate precursor applicable for such scanning exposure, a planographic printing plate precursor wherein an oleophilic photosensitive resin layer (photosensitive layer) containing a photosensitive compound that can generate an active species such as free radical, Broensted acid, or the like by laser exposure is formed on a hydrophilic support has been proposed and already commercialized. It is possible to obtain a negative-type planographic printing plate by scanning the planographic printing plate precursor with a laser according to digital information, generating such an active species and thus causing physical and chemical changes in the photosensitive layer, insolubilizing the exposed regions, and carrying out development.

In particular, a planographic printing plate precursor wherein a photopolymerizable photosensitive layer containing a photopolymerization initiator superior in sensitization speed, an addition-polymerizable ethylenic unsaturated compound, and a binder polymer soluble in an alkaline developing solution, and additionally an oxygen-blocking protective layer as needed are formed on a hydrophilic support (e.g., Japanese Patent Application Laid-Open (JP-A) No. 10-228109) is a printing plate precursor having desirable printing properties, because it is superior in productivity, has an easy developing process, and has superior resolution and inking property.

For further improvement in productivity, i.e., in platemaking speed, a recording material has been proposed employing a photopolymerizable composition containing a cyanine colorant having a particular structure, an iodonium salt and an addition polymerizable compound having an ethylenic unsaturated double bond in the photosensitive layer, which does not require heat treatment after image exposure (e.g., Japanese Patent Application Publication (JP-B) No. 7-103171). However the recording material is vulnerable to polymerization inhibition due to oxygen in the air during the polymerization reaction and thus has a problem in that the sensitivity is lowered and the intensity of the image formed in the image region is insufficient.

To overcome the problem, a method of forming a protective layer containing a water-soluble polymer on a photosensitive layer and a method of forming a protective layer containing an inorganic layered compound and a water-soluble polymer are known (e.g., JP-A No. 11-38633). Presence of the protective layer enables prevention of the polymerization inhibition, acceleration of the curing reaction of the photosensitive layer, and improvement in the intensity of the image region.

On the other hand, reduction of the time needed for the exposure step is important for improving productivity in plate making of a photopolymerizing planographic printing plate precursor, which is easily developed. Normally, the planographic printing plate precursors are sent to the exposure step as a stack containing, between the precursors, an insert paper for preventing adhesion of the plate precursors and scratches due to abrasion between the surface of the relatively soft protective layer and the aluminum support. For this reason, the period needed for removing the insert paper results in inefficiency in the exposure step. For improving the efficiency in the exposure step, it is desirable to eliminate the step of removing the insert paper by using a stack containing no insert paper between the precursors, and thus, there is a need for a method of improving the adhesion resistance of the planographic printing plate precursor and preventing scratches due to abrasion between the protective layer surface and the aluminum support. The method of forming a protective layer containing an inorganic layered compound and a water-soluble polymer described above is effective in improving the adhesion resistance between planographic printing plate precursors and also effective to some extent with respect to the rubbing scratches generated when the protective layer surface is rubbed against the aluminum support. However, the method is still insufficient with respect to scratch resistance when it is rubbed strongly against, for example, the edge portion of the aluminum support rear surface.

For these reasons, there exists a need for a planographic printing plate precursor having a photosensitive layer resistant to polymerization inhibition, that is improved in adhesion resistance between the planographic printing plate precursors and in scratch resistance between the protective layer surface and the support even when the plate precursors are stacked without insert paper and that can improve productivity in a platemaking operation.

EP 1 630 611 A discloses a negative planographic printing plate precursor comprising a support, and a photosensitive layer and a protective layer, which are formed in this sequence on or above the support, wherein the photosensitive layer comprises an infrared absorbing agent, a polymerization initiating agent, a polymerizable compound and a binder polymer comprising specific repeating units; and the protective layer comprises an inorganic lamellar compound.

The invention is aimed at solving the conventional problems discussed above and achieving the following. Specifically, the invention provides a polymerizable negative planographic printing plate precursor having a protective layer and allowing writing by an infrared laser and improvement in productivity during platemaking. More specifically, the invention provides a polymerizable negative planographic printing plate precursor, having, on a photosensitive layer allowing writing by an infrared laser, a protective layer that allows suppression of polymerization inhibition in the photosensitive layer, is superior in removability during development, suppresses adhesion between the protective-layer surface of the planographic printing plate precursor and the support rear surface of an adjacent planographic printing plate precursor when the planographic printing plate precursors are stacked, and prevents rubbing scratches between the protective layer surface and the support rear surface; a stack of the plurality of the polymerizable negative planographic printing plate precursors; and a method of producing the polymerizable negative planographic printing plate precursor.

### Summary of the Invention

The present invention has been made in view of the above circumstances and provides a polymerizable negative planographic printing plate precursor, a stack of a plurality of the planographic printing plate precursors, and a method of producing the polymerizable negative planographic printing plate precursor.

An aspect of the invention provides a polymerizable negative planographic printing plate precursor comprising a hydrophilic support, and a polymerizable negative photosensitive layer and a protective layer containing polyvinylalcohol, organic resin fine particles having an average particle diameter in a range of 2.0 to 15 µm and mica particles as the top layer formed in this order on the hydrophilic support.

Another aspect of the invention provides a stack of a plurality of the polymerizable negative planographic printing plate precursors, wherein the plurality of the planographic printing plate precursors are stacked in such a manner that the protective layer of one precursor and the support rear surface are in contact with each other.

Another aspect of the invention provides a method of producing the polymerizable negative planographic printing plate precursor, comprising applying an aqueous solution containing polyvinylalcohol, organic resin fine particles having an average particle diameter in a range of 2.0 to 15 µm, and mica particles on a polymerizable negative photosensitive layer.

### Detailed Description of the Invention

After intensive studies to solve the problems above, the inventors have found that it was possible to achieve the object with a planographic printing plate precursor having a protective layer containing polyvinylalcohol and organic resin fine particles having an average particle diameter in a range of 2.0 to 15 µm and mica particles and completed the invention.

Thus, the polymerizable negative planographic printing plate precursor according to the invention (hereinafter, referred to simply as "planographic printing plate precursor") comprises, on a hydrophilic support, a polymerizable negative photosensitive layer and a protective layer containing polyvinylalcohol, organic resin fine particles having an average particle diameter in a range of 2.0 to 15 µm and mica particles as the top layer formed in this order thereon.

In producing a planographic printing plate precursor in factory production scale, a coating solution is prepared by adding and dispersing organic resin fine particles (hereinafter referred to as particles having an average particle diameter in a range of 2.0 to 15 µm) in a protective layer-coating solution containing an aqueous polyvinylalcohol as the primary component and leaving the dispersion for about several hours to one day before coating for separation of hydrophobic organic resin fine particles in the coating solution during the period, i.e., for sedimentation of those having a specific gravity of larger than 1 sediment on the bottom of the container and floatation of those having a specific gravity of smaller than 1 float onto the liquid surface. Application of the dispersion containing organic resin fine particles separated therein causes a problem that there are regions both carrying no organic resin fine particles and carrying the aggregate in the protective layer formed on photosensitive layer.

However, it is possible to improve the dispersion stability of the organic resin fine particles and prevent the problem of separation of such organic resin fine particles in the coating solution by adding mica particles to the coating solution such a organic resin fine particles in a particular amount. Details of the reason are not clear yet, but seems to be as follows: Organic resin fine particles not surface-modified with a surface functional group has a weak negative surface charge in water at around neutral pH, and the mica particles also has a weak negative charge. The surface of the organic resin fine particles is hydrophobic and has low affinity with water, and thus, the mica particles are adsorbed on the particle surface by hydrophobic interaction. The mica/resin composite particles thus formed have an increased surface charge, and thus resistant to aggregation and sedimentation, and, in particular, particles having a specific gravity of less than 1 give composite particles having a specific gravity closer to 1 by adsorption of mica particles, which are resistant to separation in the liquid.

For that reason, in the planographic printing plate according to the invention precursor, the absolute specific gravity of the organic resin fine particles contained in the protective layer is preferably in the range of 0.90 to 1.25 and the average particle diameter of the organic resin fine particles, 2.0 to 15 µm, and additionally, the weight ratio of the organic resin fine particles to the mica particle (organic resin fine particles: mica particle) is preferably in the range of 3:1 to 2:3.

In addition, in the planographic printing plate precursor according to the invention, the photosensitive layer preferably contains an infrared absorbent, a polymerization initiator, a polymerizable compound and a binder polymer.

In the planographic printing plate according to the invention precursor, the binder polymer in the photosensitive layer is preferably a binder polymer having a repeating unit represented by the following Formula (i): 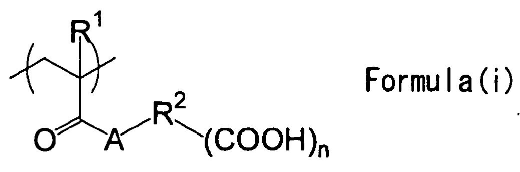 wherein, in Formula (i), R¹ represents a hydrogen atom or a methyl group; R² represents a connecting group containing two or more atoms selected from a group consisting of carbon, hydrogen, oxygen, nitrogen and sulfur and having a total number of atoms of 2 to 82 atoms; A represents an oxygen atom or -NR³-; R³ represents a hydrogen atom or a monovalent hydrocarbon group having 1 to 10 carbon atoms; and n denotes an integer of from 1 to 5.

The laminate of the planographic printing plate precursors according to the invention is characterized in that multiple planographic printing plate precursors according to the invention are stacked with a protective layer of one precursor and the support rear surface of an adjacent precursor in direct contact with each other, and the method of producing the planographic printing plate precursor according to the invention is characterized by applying an aqueous solution containing polyvinylalcohol, organic resin fine particles, and mica particles on a polymerizable negative-type photosensitive layer.

The invention provides a polymerizable negative planographic printing plate precursor having a protective layer and thus, allowing writing by infrared laser and improvement in productivity during platemaking.

More specifically, the invention provides a polymerizable negative planographic printing plate precursor, having, on a photosensitive layer allowing writing by infrared laser, a protective layer that allows suppression of polymerization inhibition in the photosensitive layer, is superior in safelight endurance, storage life over time, and removability during development, restricts adhesion between the protective-layer surface of the planographic printing plate precursor and the support rear surface of the adjacent planographic printing plate precursor when the planographic printing plate precursors are stacked, and prevents rubbing scratch between the protective layer surface of one precursor and the support rear surface of an adjacent precursor; a stack of the plurality of the polymerizable negative planographic printing plate precursors; and a method of producing the polymerizable negative planographic printing plate precursor.

### <Planographic printing plate precursor>

The polymerizable negative planographic printing plate precursor according to the invention characteristically has a hydrophilic support, and a polymerizable negative photosensitive layer and a protective layer containing polyvinylalcohol, organic resin fine particles and mica particles as the top layer formed thereon in this order.

Hereinafter, the components for the planographic printing plate precursor according to the invention will be described.

### <Protective layer>

The protective layer according to the invention characteristically contains a polyvinylalcohol, organic resin fine particles, and mica particles.

Because the photosensitive layer in the planographic printing plate precursor according to the invention is a polymerizable negative photosensitive layer (as will be described below), a protective layer is formed on the photosensitive layer for prevention of contamination of the low-molecular weight compounds such as oxygen, moisture, and basic substances present in air, which inhibit image-forming reaction, because the planographic printing plate precursor is exposed to light in air.

Containing polyvinylalcohol, organic resin fine particles, and mica particles to the protective layer formed for that purpose leads to drastic stabilization of the organic resin fine particles in the coating solution, and a planographic printing plate precursor prepared by using the coating solution always has superior film strength and also has a matte-surfaced protective layer. As a result, the protective layer becomes improved in sensitivity, storage life over time, and safelight endurance, and resistant to deterioration for example by deformation and scratching. In addition, presence of the matte-surfaced protective layer is effective in preventing adhesion between the protective-layer surface of the planographic printing plate precursor and the support rear surface of the adjacent planographic printing plate precursor and rubbing scratch between the protective layer surface and the support rear surface when the planographic printing plate precursors according to the invention are stacked. Hereinafter, the organic resin fine particles, mica particles and polyvinylalcohol will be described.

### (Organic resin fine particles)

The organic resin fine particle according to the invention is a matting agent added for prevention of adhesion between the protective-layer surface of the planographic printing plate precursor and the support rear surface of the adjacent planographic printing plate precursor and the rubbing scratch between the surface of the protective layer and the rear surface of the support (e.g., aluminum support). The basic characteristics demanded for the fine particles used as a matting agent include resistance to softening and sticking by moisture in air or by heating and capability to make the protective layer surface irregular and thereby reduce the adhesive surface area, without practical inhibition of light transmission for exposure. From the viewpoints of effective prevention of rubbing scratch, the organic resin fine particle is preferably, relatively softer and elastic, allowing relaxation of the stress occurring when the protective layer is rubbed, for example, against the hard aluminum face. Further, the fine particle is preferably more compatible with polyvinylalcohol, the binder for the protective layer, well blended in the film, and resistant to separation form the film surface.

The average particle diameter of the organic resin fine particles is 2.0 to 15 µm, preferably 3.0 to 12 µm. The particle diameter distribution may be monodispersion or polydispersion, however monodispersion is more preferable.

The average particle diameter can be determined according to Coulter-counter method.

Examples of the organic resin fine particles having such properties include synthetic resin particles such as of poly(meth)acrylic esters, polystyrene and the derivatives thereof, polyamides, polyimides, polyolefins such as low-density polyethylene, high-density polyethylene and polypropylene, and copolymers thereof with polyvinyl alcohol, polyurethanes, polyureas, and polyesters; and natural polymer fine particles such as of chitin, chitosan, cellulose, crosslinked starch, and crosslinked cellulose. In particular, synthetic resin fine particles have advantages, for example, in easier control of particle size and surface properties by surface modification. The synthetic resin for the organic resin fine particles is particularly preferably an acrylic or polyolefin resin having a specific gravity in the range of 0.90 to 1.01.

Such organic resin fine particles may be prepared by crushing if the resin is relatively harder, however a method of forming particles by emulsification-suspension polymerization is mainly employed, from the viewpoints of easiness and accuracy in controlling particucle size. Methods of producing such fine particles are described in detail, for example, in "Ultrafine Particles and Materials", Materials Science Society of Japan Ed., Shokabo Publishing Co., Ltd. 1993, and "Fine particles - Preparation and Application of Powder", Haruma Kawaguchi Ed., CMC Publishing Co., Ltd. 2005, and others. Examples of commercially available organic resin fine particles include crosslinked acrylic resins MX-300, MX-500, MX-1000, MX-1500H, MR-2HG, MR-7HG, MR-10HG, MR-3GSN, MR-5GSN, MR-7G, MR-10G, MR-5C, and MR-7GC, and styryl resins SX-350H and SX-500H, manufactured by Soken Chemical & Engineering Co., Ltd.; acrylic resins MBX-5, MBX-8, MBX-12, MBX-15, MBX-20, MB20X-5, MB30X-5, MB30X-8, MB30X-20, SBX-6, SBX-8, SBX-12, and SBX-17, manufactured by Sekisui Plastics Co., Ltd.; a hollow acrylic resin MBP-8 manufactured by Sekisui Plastics Co., Ltd.; polyolefin resins Chemipearl W100, W200, W300, W308, W310, W400, W401, W405, W410, W500, WF640, W700, W800, W900, W950, and WP100 manufactured by Mitsui Chemicals, Inc..

These fine particles, when supplied as powder, are dispersed in an aqueous solution of the polyvinylalcohol for the protective layer in a simple dispersing machine such as homogenizer, homomixer, ball mill, or paint shaker. A surfactant may then be added as needed for more stabilization of the dispersed particles. The surfactant for use in such a dispersion may be any one of nonionic, anionic, and cationic surfactants. Examples of the nonionic surfactants include polyethylene glycol alkylethers, alkenylethers, polyethylene glycol alkyl esters, polyethylene glycol arylethers. Examples of the anionic surfactants include surfactants of alkyl or aryl sulfonate salts, alkyl or aryl sulfate ester salts, alkyl or aryl phosphate ester salts, and alkyl or arylcarboxylate salts. Examples of the cationic surfactants include surfactants of alkylamine salts, alkylpyridinium salts, and alkylammonium salts. More specifically, specific examples of the surfactants include those described in "Up-to-date Function, Raw material, and Application of Surfactants", Teruo Terauchi and Toshiyuki Suzuki, Gijutu Kyoiku Shuppansha.

The Chemipearl series organic resin fine particles manufactured by Mitsui Chemicals, Inc. are supplied as dispersed in water, and these dispersions may be added directly to the aqueous protective layer solution for preparation of the protective layer-coating solution.

The organic resin fine particles contained in the protective layer preferably have an absolute specific gravity in the range of 0.90 to 1.25 and an average particle diameter of 2.0 to 15 µm, and more preferably an absolute specific gravity in the range of 0.90 to 1.20 and an average particle diameter of 3.0 to 12 µm.

The absolute specific gravity is determined according to the method specified by JIS-K6760.

The content of the organic resin fine particles is preferably 1.0 to 20 mass%, more preferably 2.0 to 10 mass%, with respect to the solid content in the protective layer. An excessively smaller addition amount may lead to decrease in surface matting effect and deterioration in adhesion and abrasion resistance, while an excessively larger addition amount, to troubles such as deterioration in sensitivity and separation of the particles from the protective layer surface.

### (Mica particle)

The mica particle for use in the invention is for example, a group of mica such as natural mica and synthetic mica represented by the following Formula:

Formula: A(B,C)₂-5D₄O)₁₀(OH,F,O)₂

[wherein, A represents K, Na, or Ca; B and C each represent Fe (II), Fe (III), Mn, Al, Mg, or V; and D represents Si or Al].

Specific examples of the micas represented by the Formula above and other micas for use in the invention include white mica, soda mica, phlogopite, black mica, and scaly mica.

Examples of the synthetic micas include non-swelling micas such as fluorine phlogopite KMg₃(AlSi₃O₁₀)F₂ and potassium tetrasilicic mica KMg_{2.5}(Si₄O₁₀)F₂; and swelling micas such as Na tetrasilicic mica NaMg_{2.5}(Si₄O₁₀)F₂, Na or Li taeniolite (Na,Li)Mg₂Li(Si₄O₁₀)F₂, and montmorillonite-based Na or Li hectorite (Na,Li)_{1/8}Mg_{2/5}Li_{1/8}(Si₄O₁₀)F₂. Synthetic smectites are also useful.

In the invention, fluorine-based swelling micas are particularly useful among the mica particles above. The swelling synthetic mica has a layer structure having a unit crystal lattice layer of approximately 10 to 15 Å (1 nm to 1.5 nm) in thickness and allow substitution of the metal atoms in the lattice significantly easier than other clay minerals. As a result, the lattice layer becomes deficient in the amount of positive charges and absorbs cations such as Li⁺, Na⁺, Ca²⁺, or Mg²⁺ into the space between the layers to compensate the deficiency. The interlayer cation, which is called exchangeable cation, can be replaced with various cations. In particular when the interlayer cation is Li⁺ or Na⁺, the mica swells significantly in the presence of water, because the bond between lamellar crystal lattices is weaker due to the small ionic radius of the interlayer cation. Thus, the mica is easily cleaved when a shear is applied in the state, giving a sol stabilized in water. Swelling synthetic micas have such a tendency more strongly, and thus, are useful and used particularly preferably in the invention.

As for the shape of the lamellar inorganic compound for use in the invention, the thickness is preferably smaller as much as possible from the viewpoint of absorption to organic resin fine particles, and the plane size is preferably larger, as long as the smoothness of coated surface or the transmission of activated light is not impaired. Thus, the aspect ratio is 20 or more, preferably 100 or more, and particularly preferably 200 or more. The aspect ratio is a ratio of the thickness to the length of particle, and is determined, for example, from the projected drawing of the particle in micrograph. Mica having a greater aspect ratio gives a greater advantageous effect.

The mica particles for use in the invention preferably have an average major axis of 0.3 to 20 µm, more preferably 0.5 to 10 µm, and particularly preferably 1 to 5 µm. The average thickness of the particle is preferably 0.1 µm or less, more preferably 0.05 µm or less, and particularly preferably 0.01 µm or less. Specifically, a typical compound, swelling synthetic mica, has a thickness of 1 to 50 nm and a plane size (major axis) of approximately 1 to 20 µm.

The amount of the mica particles contained in the protective layer may vary according to the addition amount and the kind of the organic resin fine particles, however the rate of organic resin fine particles to mica particles (organic resin fine particles: mica particles) is preferably in the range of 3:1 to 2:3, more preferably in the range of 2:1 to 1:1, by mass. An excessively smaller amount with respect to the organic resin fine particles leads to less effective improvement in the dispersion, while an excessively larger amount, to deterioration in abrasion resistance when the layer is abraded with the rear surface of the support. Also when multiple kinds of mica particles are used, the total amount of these mica particles is preferably in the range above by mass.

### (Polyvinylalcohol)

Preferably, the protective layer for the planographic printing plate precursor according to the invention is highly adhesive to the photosensitive layer, has the less adhesive surface, and can be easily removed in the developing step after exposure.

Polyvinylalcohol is used as a binder component for the protective layer in the invention, to give the protective layer such preferable properties. Polyvinylalcohol has a preferable film-forming property and gives a relatively less adhesive surface.

The polyvinylalcohol for use in the invention preferably has a saponification degree of 85 to 99 mole%, more preferably 91 to 99 mole%. The polyvinylalcohol for use in the invention may be partially substituted or modified with an ester, ether, or acetal group and may also have another copolymerization component partially, if the saponification degree falls in this range, and it has unsubstituted vinylalcohol units needed for giving a desirable oxygen-blocking property and has a less adhisive surface.

Generally, a higher saponification degree of the PVA used (higher content of the unsubstituted vinylalcohol units in the protective layer) leads to a higher oxygen-blocking property and thus is advantageous from the point of sensitivity. Accordingly, it is possible to improve the oxygen-blocking property of the protective layer according to the invention, for example, by using a polyvinylalcohol having a saponification degree of 91 mole% or more and mica particles in combination.

The molecular weight of the polyvinylalcohol is preferably in the range of 200 to 2,400. Specific examples thereof include PVA-102, PVA-103, PVA-104, PVA-105, PVA-110, PVA-117, PVA-120, PVA-124, PVA-117H, PVA-135H, PVA-HC, PVA-617, PVA-624, PVA-706, PVA-613, PVA-CS, and PVA-CST manufactured by Kuraray Co. Ltd.; Gohsenol NL-05, NM-11, NM-14, AL-06, P-610, C-500, A-300, and AH-17 manufactured by Nippon Synthetic Chemical Industry Co., Ltd.; JF-04, JF-05, JF-10, JF-17, JF-17L, JM-05, JM-10, JM-17, JM-17L, JT-05, JT-13, and JT-15 manufactured by manufactured by Japan VAM & POVAL Co., Ltd..

Acid-modified polyvinylalcohols are also used preferably. Specifically, carboxy-modified polyvinylalcohols, for example modified with itaconic acid or maleic acid, and sulfonic acid-modified polyvinylalcohols are preferable. The acid-modified polyvinylalcohol is also used particularly preferably, if it has a saponification degree of 91 mol% or more. Specific examples of the acid-modified polyvinylalcohols include KL-118, KM-618, KM-118, SK-5102, MP-102, and R-2105 manufactured by Kuraray Co. Ltd.; Gohsenal CKS-50, T-HS-1, T-215, T-350, T-330, and T-330H manufactured by Nippon Synthetic Chemical Industry Co., Ltd.; AF-17 and AT-17 manufactured by Japan VAM & POVAL Co., Ltd..

The polyvinylalcohol is preferably contained in an amount in the range of 45 to 95 mass%, more preferably in the range of 50 to 90 mass%, with respect to the total solid content in the protective layer. A content of less than 45 mass% causes a concern about insufficient film-forming efficiency and deterioration in sensitivity, while a content of more than 95 mass% makes it less effective to prevent adhesion between layered planographic printing plate precursors.

The polyvinylalcohols may be used alone or in combination of two or more. When multiple polyvinylalcohols are used in combination, the total amount thereof is preferably in the weight range above.

The amount of the polyvinylalcohol in the protective layer is determined, considering desirable oxygen-blocking property, removability during development, fog, adhesiveness, and scuff resistance.

The protective layer according to the invention has an oxygen permeability of 0.5 ml/m²·day or more and 100 ml/m²·day or less at 25°C and 60% RH under 1 atmospheric pressure, and thus, the composition satisfying the requirement in oxygen permeability is selected.

A colorant (water-soluble dye) that transmits the light used for irradiating the photosensitive layer (such as infrared light) efficiently and absorbs efficiently the light having a wavelength not associated with exposure may be added to the protective layer according to the invention. In this way, it is possible to raise safelight endurance without reducing sensitivity.

### (Formation of protective layer)

The protective layer according to the invention is formed by mixing a dispersion of organic resin fine particles and a dispersion of mica particles prepared separately; preparing a protective layer-coating solution by mixing the mixture of the dispersions with a binder component containing polyvinylalcohol (or, aqueous solution of a binder component containing polyvinylalcohol); and applying the solution on a photosensitive layer.

First, an example of the general method of dispersing the mica compound for use in the protective layer will be described. First, 5 to 10 parts by mass of a swelling mica compound, one of the preferable mica compounds described above, is added to 100 parts by mass of water, allowing the mica to become compatible and swell with water, and then, the mixture is dispersed in a dispersing machine. Examples of the dispersing machines for use then include various mills that disperse while a mechanical force directly is supplied, high-speed-agitating dispersing machines having a large shearing force, dispersing machines applying a high-strength ultrasonic energy. Specific examples thereof include ball mill, sand grinder mill, visco mill, colloid mill, homogenizer, dissolver, polytron, homomixer, homoblender, Keddy mill, jet agitator, capillary emulsifier, liquid siren, electromagnetic-distortion ultrasonic wave generator, emulsifier having a Pallmann whistle.The dispersion of the mica compound at a concentration of 2 to 15 mass% prepared by the method above is highly viscous or in the gel state, and the storage stability thereof is extremely preferable.

In preparing a coating solution for protective layer by using the dispersion, the dispersion is preferably mixed with the aqueous dispersion of organic resin fine particles and stirred sufficiently and mixed with a binder component containing the particular polyvinylalcohol (or, aqueous solution dissolved with a binder component containing the particular polyvinylalcohol).

Known additives such as surfactant for improving coating efficiency and water-soluble plasticizer for improving the physical properties of film may be added to the coating solution for protective layer. Examples of the water-soluble plasticizers include propionamide, cyclohexanediol, glycerol, sorbitol. In addition, a water-soluble (meth)acrylic polymer may be added. Further, known additives for improvement in the adhesiveness with photosensitive layer and the storability of coating solution may be added to the coating solution.

The method of forming the protective layer according to the invention is not particularly limited, and the method described in U.S. Patent No. 3,458,311 or JP-A No. 55-49729 may be used.

The coating amount of the protective layer according to the invention is preferably 0.1 to 4.0 g/m², more preferably 0.3 to 3.0 g/m². A coating amount of less than 0.1 g/m² may result in inferior film strength of the protective layer and deterioration in abrasion resistance. Alternatively, a coating amount of more than 4.0 g/m² may lead to scattering of the incident light entering into the protective layer by photoirradiation, consequently to deterioration in mage quality and excessively lowered oxygen permeability, which in turn leads to deterioration in safelight endurance.

### <Photosensitive layer>

The photosensitive layer for the planographic printing plate precursor according to the invention is preferably a polymerizable negative photosensitive layer, in particular a photosensitive layer polymerizing by irradiation of infrared laser, and more preferably, a polymerizable negative photosensitive layer containing an infrared absorbent, a polymerization initiator, a polymerizable compound, and a binder polymer, as well as a colorant and any other components as needed.

The polymerizable negative photosensitive layer according to the invention is preferably sensitive to infrared light and also to infrared laser, which is useful for CTP printing. The infrared absorbent contained therein is activated into the electron excited state at high sensitivity by infrared laser irradiation (photoirradiation), and the electron transfer, energy transfer, and heat generation (photothermal-converting function) associated with the electron excited state act to the polymerization initiator co-present in the photosensitive layer, inducing chemical change of the polymerization initiator and generating radicals.

Possible mechanisms for generation of radical include: (1) the heat generated by the photothermal-converting function of infrared absorbent decomposes the polymerization initiator described below (e.g., sulfonium salt) thermally, generating radicals; (2) the excited electron generated in infrared absorbent is transferred to the polymerization initiator (e.g., active halogen compound), generating radicals; and (3) electron transfer from polymerization initiator (e.g., borate compound) to the excited infrared absorbent generates radicals. The generated radicals initiate the polymerization reaction of the polymerizable compound, forming an image region by hardening the exposed area.

The planographic printing plate precursor according to the invention, which has a photosensitive layer containing an infrared absorbent, is particularly preferable for use in direct printing with infrared laser beam having a wavelength of 750 to 1,400 nm, and shows an image-forming property higher than conventional planographic printing plate precursors.

Hereinafter, components used in the photosensitive layer according to the invention will be described below.

### (Infrared absorbent)

The photosensitive layer according to the invention contains an infrared absorbent for energy-transfer (electron transfer) or photothermal-conversion.

The infrared absorbent is activated into the electron excited state at highly sensitive by irradiation with infrared laser (exposure), and is effective in inducing the electron transfer, energy transfer, and heat generation (photothermal-converting function) associated with the electron excited state to act to the polymerization initiator described below, causing chemical change of the polymerization initiator at high sensitivity to generate radicals.

The infrared absorbent for use in the invention is preferably a dye or pigment having the absorption maximum at a wavelength of 750 to 1,400 nm.

Examples of the dyes include commercially available dyes and those known in the art, for example, those described in "Dye Handbook" (Soc. Synthetic Organic Chemistry Ed., 1970) and others. Specific examples thereof include azo dyes, metal complex salt azo dyes, pyrazolone azo dyes, naphthoquinone dyes, anthraquinone dyes, phthalocyanine dyes, carbonium dyes, quinonimine dyes, methine dyes, cyanine dyes, squarilium colorants, and dyes of pyrylium salts, and metal thiolate complexes.

Preferable examples of the dyes include the cyanine dyes described in JP-A Nos. 58-125246, 59-84356, and 60-78787, and others; the methine dyes described in JP-A Nos. 58-173696, 58-181690, and 58-194595 and others; the naphthoquinone dyes described in JP-A Nos. 58-112793, 58-224793, 59-48187, 59-73996, 60-52940, and 60-63744 and others; the squarilium colorants described in JP-A No. 58-112792 and others; the cyanine dyes described in British Patent No. 434,875.

Also preferably used are the near infrared-absorbing sensitizers described in U.S. Patent No. 5,156,938; the substituted arylbenzo(thio)pyrylium salts described in U.S. Patent No. 3,881,924; the trimethine thiopyrylium salts described in JP-A No. 57-142645 (U.S. Patent No. 4,327,169); the pyrylium-based compounds described in JP-A Nos. 58-181051, 58-220143, 59-41363, 59-84248, 59-84249, 59-146063, and 59-146061; the cyanine colorants described in JP-A No. 59-216146; the pentamethine thiopyrylium salts and others described in U.S. Patent No. 4,283,475; and the pyrylium compounds described in JP-B Nos. 5-13514 and 5-19702. Other preferable examples of the dyes include the infrared-absorbing dyes represented by Formulae (I) and (II) described in U.S. Patent No. 4,756,993.

Yet other preferable examples of the photoabsorbing materials used in the embodiment include the particular indolenine cyanine colorants described in JP-A No. 2002-278057 exemplified below:

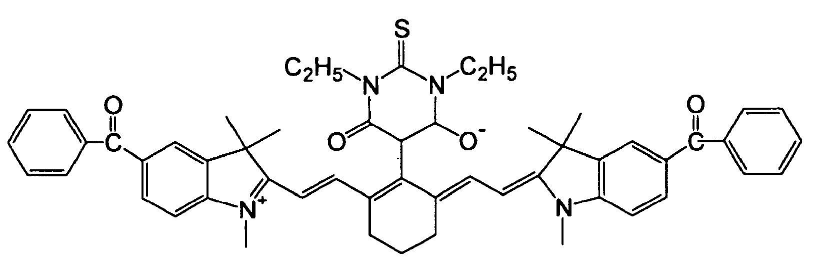

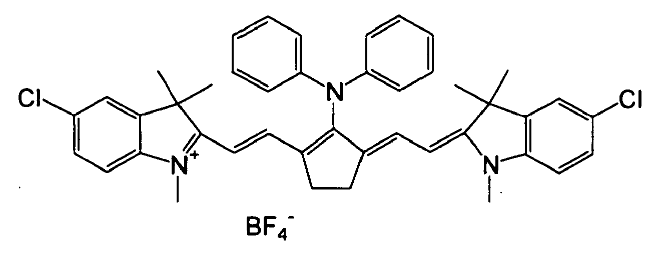

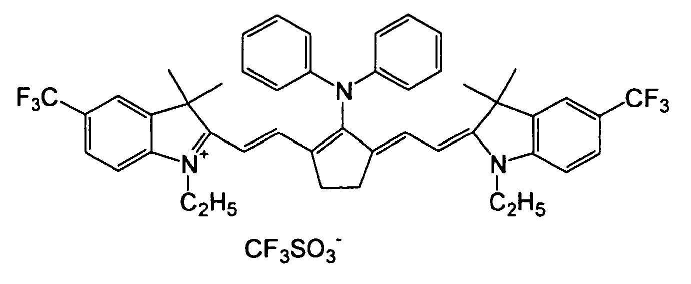

Particularly preferable among the dyes are cyanine dyes, squarilium dyes, pyrylium salts, nickel thiolate complexes, and indolenine cyanine dyes. Cyanine dyes and indolenine cyanine dyes are more preferable, and cyanine dyes represented by the following Formula (a) are particularly preferable.

### Formula (a)

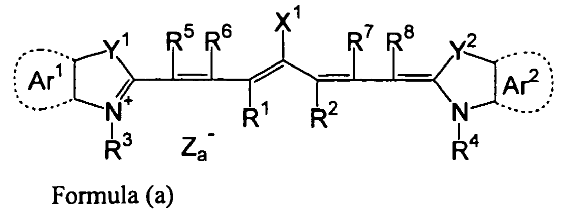

In Formula (a), X¹ represents a hydrogen or halogen atom, -NPh₂, X² -L¹ or a group shown below group.

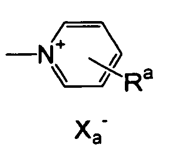

In the Formula, X² represents an oxygen, nitrogen, or sulfur atom; and L¹ represents a hydrocarbon group having 1 to 12 carbon atoms, a heteroatom-containing aromatic ring, or a heteroatom-containing hydrocarbon group having 1 to 12 carbon atoms. The heteroatom represents N, S, O, a halogen atom, or Se. Xₐ⁻ is the same as Zₐ⁻ described below; and R^{a} represents a substituent group selected from a hydrogen atom, alkyl groups, aryl groups, substituted and unsubstituted amino groups, and halogen atoms.

R¹ and R² each independently represent a hydrocarbon group having 1 to 12 carbon atoms. From the point of the storage stability of image-recording layer coating solution, R¹ and R² preferably represent a hydrocarbon group having two or more carbon atoms; and particularly preferably, R¹ and R² bind to each other, forming a five- or six-membered ring.

Ar¹ and Ar² may be the same as or different from each other, and each represent an aromatic hydrocarbon group which may be substituted. Preferable aromatic hydrocarbon groups include benzene and naphthalene rings. Preferable substituent groups include hydrocarbon groups having 12 or fewer carbon atoms, halogen atoms, and alkoxy groups having 12 or fewer carbon atoms. Y¹ and Y² may be the same as or different from each other, and each represent a sulfur atom or a dialkylmethylene group having 12 or fewer carbon atoms. R³ and R⁴ may be the same as or different from each other, and each represent a hydrocarbon group having 20 or fewer carbon atoms that may be substituted. Preferable substituent groups thereon include alkoxy groups having 12 or fewer carbon atoms, a carboxyl group, and a sulfo group. R⁵, R⁶, R⁷ and R⁸ may be the same as or different from each other, and each represent a hydrogen atom or a hydrocarbon group having 12 or fewer carbon atoms. The group is preferably a hydrogen atom, from the point of availability of the raw material. Zₐ⁻ represents a counter anion. However, when the cyanine colorant represented by Formula (a) has an anionic substituent group in the structure and there is no need for neutralization of the electric charge, Zₐ⁻ is unnecessary. Preferably from the point of the storage stability of image-recording layer coating solution, Zₐ⁻ represents a halide, perchlorate, tetrafluoroborate, hexafluorophosphate, or sulfonate ion, particularly preferably a perchlorate, hexafluorophosphate, or aryl sulfonate ion.

Specific examples of the cyanine colorants represented by Formula (a) preferably used in the embodiment include those described in JP-A No. 2001-133969, paragraph numbers [0017] to [0019].

Particularly preferable other examples thereof include the particular indolenine cyanine colorants described above in JP-A No. 2002-278057.

However, compounds having no halide ion as the counter ion are particularly preferable.

Examples of the pigments for use in the invention include commercially available pigments and the pigments described in Color Index (C.I.) Handbook, "Pigment Handbook" (Japan Society of pigment technologies Ed., 1977), "State-of-the-Art Pigment Application Technologies" (CMC Publishing Co., Ltd., 1986), "Printing Ink Technology" (CMC Publishing Co., Ltd., 1984).

Examples of the pigments include black pigments, yellow pigments, orange pigments, brown pigments, red pigments, purple pigments, blue pigments, green pigments, fluorescent pigments, metal powder pigments, as well as polymer-bound colorants. Specific examples thereof include insoluble azo pigments, azolake pigments, condensation azo pigments, chelate azo pigments, phthalocyanine pigments, anthraquinone-based pigments, perylene and perynone-based pigments, thioindigo-based pigments, quinacridone-based pigments, dioxazine-based pigments, isoindolinone-based pigments, quinophtharone-based pigments, dyed lake pigments, azine pigments, nitroso pigments, nitro pigments, natural pigments, fluorescent pigments, inorganic pigments, carbon black. Among these pigments, preferable is carbon black.

These pigments may be used either with or without surface treatment. Examples of the surface treatment methods include methods of coating a resin or wax on the surface of pigment; of attaching a surfactant thereon; of binding a reactive substance (e.g., silane coupling agent, epoxy compound, or polyisocyanate, ) to the surface of pigment. The surface treatment methods above are described in "Properties and Applications of Metal Soaps" (Saiwai Shobo), "Printing Ink Technologies" (CMC Publishing Co., Ltd., 1984) and "State-of-the-Art Pigment Application Technologies" (CMC Publishing Co., Ltd., 1986).

The particle diameter of the pigment is preferably in the range of 0.01 to 10 µm, more preferably of 0.05 to 1 µm, and particularly preferably of 0.1 to 1 µm. Preferably in the range above, the pigment is dispersed in the image-recording layer coating solution, giving an image-recording layer superior in uniformity.

For dispersing a pigment, any one of the dispersion techniques known in the art and used for production of inks and toners may be used. Suitable dispersing machines include ultrasonic dispersing machine, sand mill, attriter, pearl mill, super mill, ball mill, impeller, disperser, KD mill, colloid mill, dynatron, three roll mill, pressurized kneader. More detailed description on such dispersing machines is found in the "State-of-the-Art Pigment Application Technologies" (CMC Publishing Co., Ltd., 1986).

When used in the photosensitive layer according to the invention, the infrared absorbent may be added to the layer identical with other components, or to another layer.

These infrared absorbents are preferably added in an amount of 0.01 to 50%, preferably 0.1 to 10% by mass with respect to the total solid contents in the photosensitive layer, from the viewpoints of the uniformity and the durability in photosensitive layer, and particularly preferably 0.5 to 10% by mass if the absorbent is a dye, and particularly preferably 0.1 to 10% by mass if the absorbent is a pigment.

### (Polymerization initiator)

The polymerization initiator for use in the invention has a function to initiate and advance the curing reaction of polymerizable compound described below, and any compounds that generate active radicals by application of energy, such as thermal decomposition-type radical generators that generate free radicals by decomposition by heat, electron transfer-type radical generators that generate free radicals by accepting an excited electron of infrared absorbent, and electron transfer-type radical generators that generate free radicals by transferring an electron to the excited infrared absorbent, may be used as the polymerization initiator. Examples thereof include onium salts, activated halogen compounds, oxime ester compounds, borate compounds. These compounds may be used in combination. In the invention, onium salts are preferable, and sulfonium salts are particularly preferable among them.

The sulfonium salt polymerization initiators preferably used in the invention include onium salts represented by the following Formula (1).

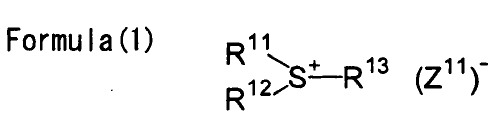

In Formula (1), R¹¹, R¹² and R¹³ may be the same or different from each other, and each represent a hydrocarbon group having 20 or less carbons which may have one or more substituents. The preferable substituents include halogen atoms, a nitro group, alkyl groups having 12 or less carbons, alkoxy groups having 12 or less carbons, and aryloxy groups having 12 or less carbons. (Z¹¹)⁻ represents a counter ion selected from the group consisting of a halide ion, perchlorate ion, tetrafluoroborate ion, hexafluorophosphate ion, carboxylate ion, and sulfonate ion, and preferably, perchlorate ion, hexafluorophosphate ion, carboxylate ion, or arylsulfonate ion.

Specific examples of the onium salts represented by Formula (1) ([OS-1] to [OS-12]) are shown below but are not limited thereto.

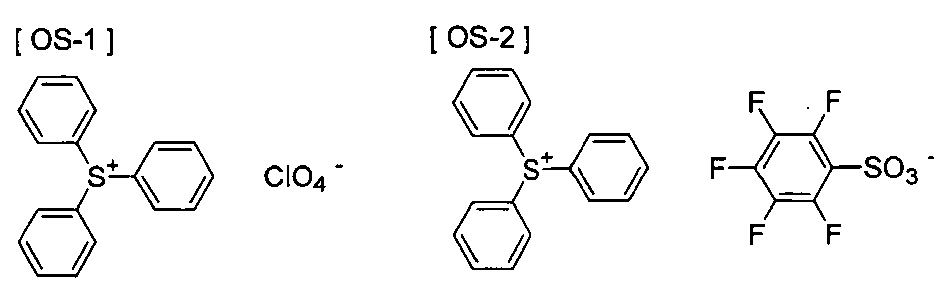

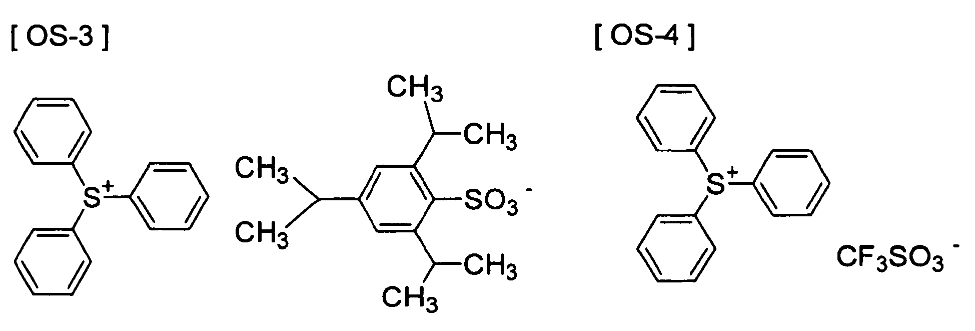

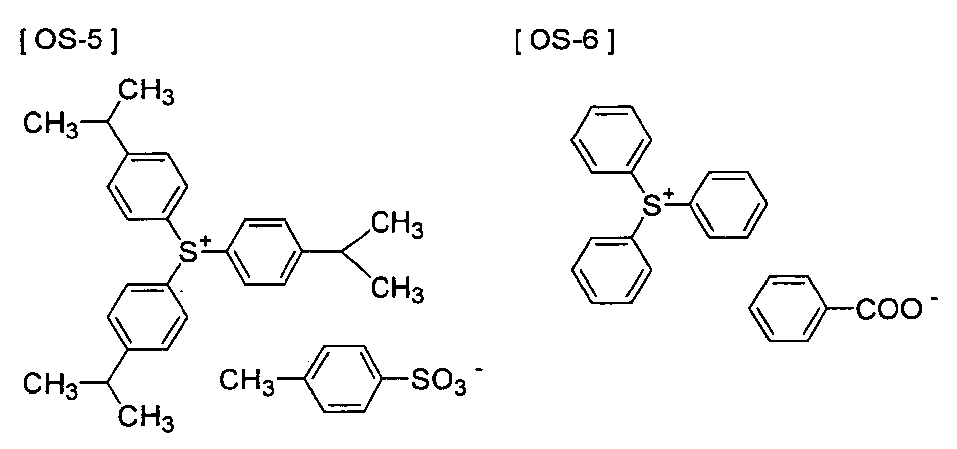

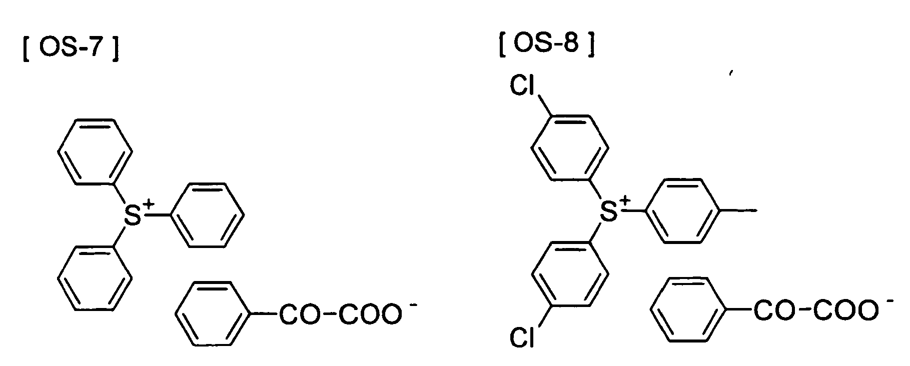

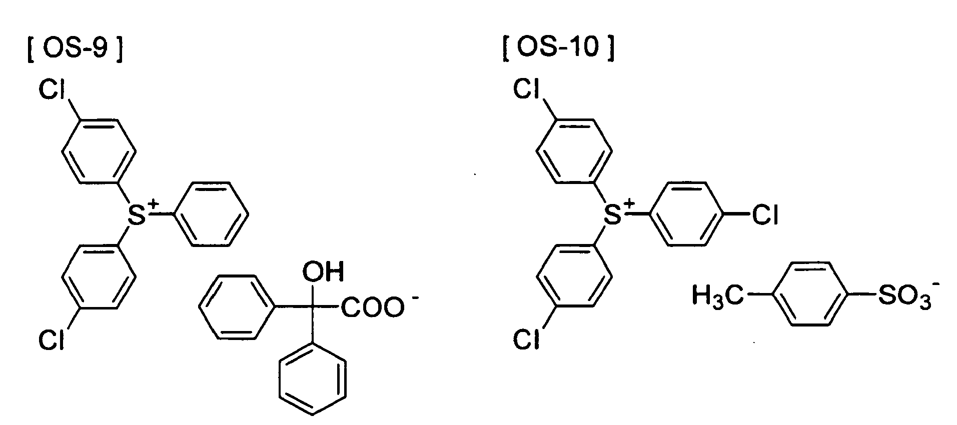

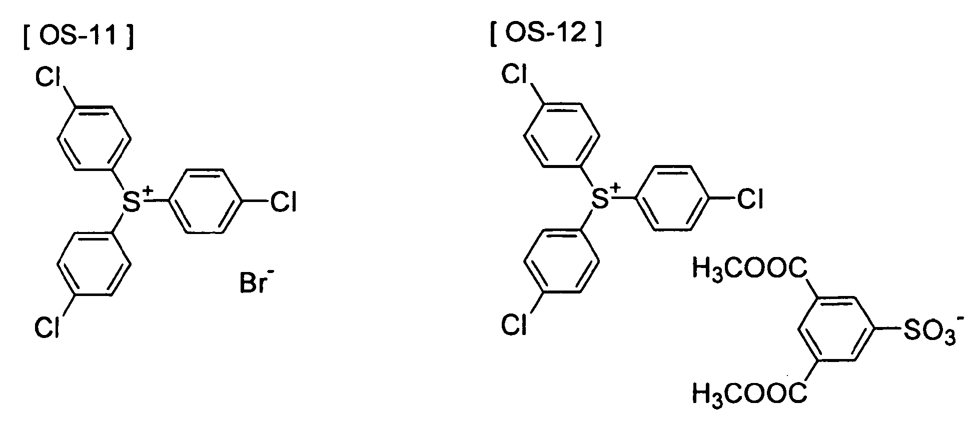

In addition to the compounds above, particular aromatic sulfonium salts described in JP-A Nos. 2002-148790, 2002-350207, and 2002-6482 may also be used preferably.

In the invention, in addition to the sulfonium salt polymerization initiators, other polymerization initiators (other radical generator) may also be used. The other radical generators include onium salts other than sulfonium salts, triazine compounds having a trihalomethyl group, peroxides, azo-based polymerization initiators, azide compounds, quinone diazide, activated halogen compounds, oxime ester compounds, triaryl monoalkyl borate compounds, and among them, onium salts are preferable, as they are highly sensitive. In addition, a mixture containing a sulfonium salt polymerization initiator as the essential component and one of these polymerization initiators (radical generators) may also be used.

The other onium salts preferably used in the invention include iodonium salts and diazonium salts. In the invention, these onium salts function not as an acid generator but as an initiator of radical polymerization.

The other onium salts for use in the invention include the onium salts represented by the following Formulae (2) and (3).

Formula (2) Ar²¹-I⁺-Ar²² (Z²¹)⁻

Formula (3) Ar³¹-N⁺≡N (Z³¹)⁻

In Formula (2), Ar²¹ and Ar²² each independently represent an aryl group having 20 or less carbons which may have one or more substituents. If the aryl group is substituted, the preferable substituents include halogen atoms, a nitro group, alkyl groups having 12 or less carbons, alkoxy groups having 12 or less carbons, and aryloxy groups having 12 or less carbons. (Z²¹)⁻ represents the counter ion identical with (Z¹¹)⁻.

In Formula (3), Ar³¹ represents an aryl group having 20 or less carbons which may have one or more substituents. Preferable substituents include halogen atoms, a nitro group, alkyl groups having 12 or less carbons, alkoxy groups having 12 or less carbons, aryloxy groups having 12 or less carbons, alkylamino groups having 12 or less carbons, dialkylamino groups having 12 or less carbons, arylamino group having 12 or less carbons, and diarylamino groups having 12 or less carbons. (Z³¹)⁻ represents the counter ion identical with (Z¹¹)⁻.

Hereinafter, specific examples of the onium salts represented by Formula (2) ([OI-1] to [OI-10]), and the onium salt represented by Formula (3) ([ON-1] to [ON-5]) preferably used in the invention are listed but are not limited thereto.

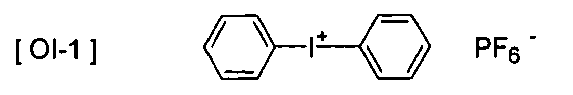

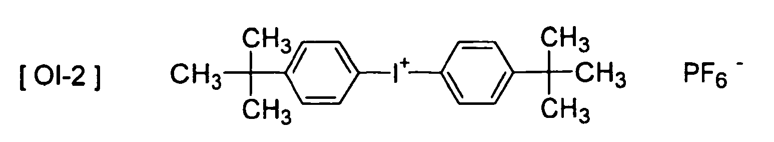

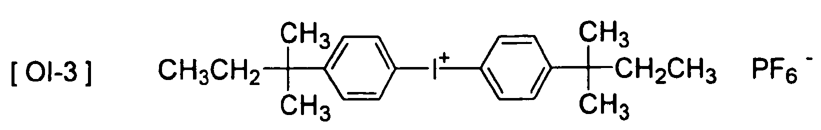

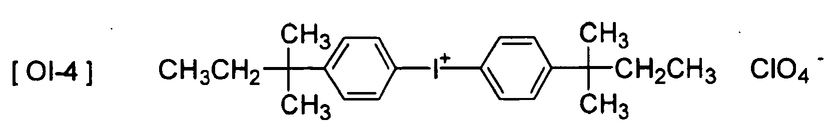

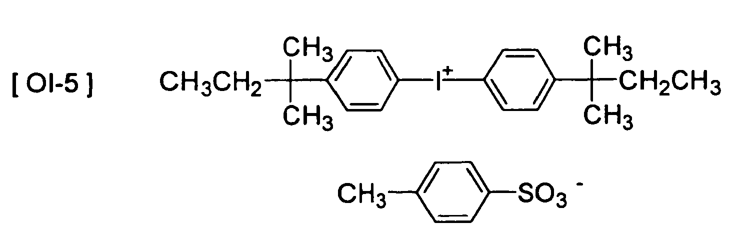

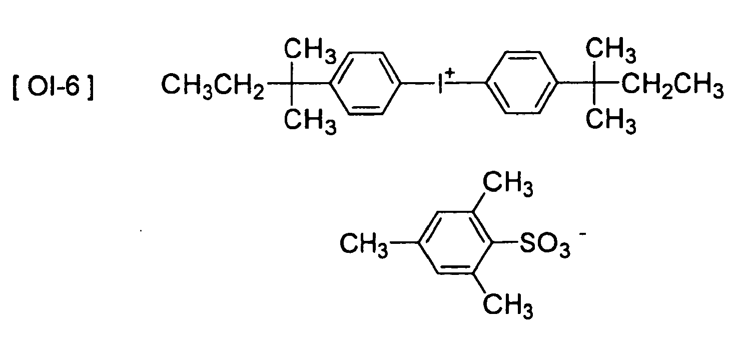

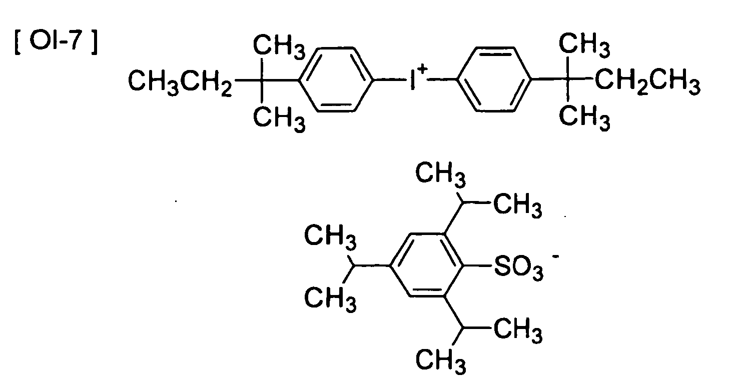

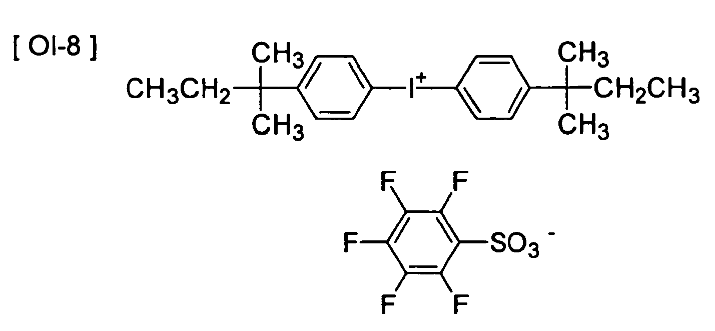

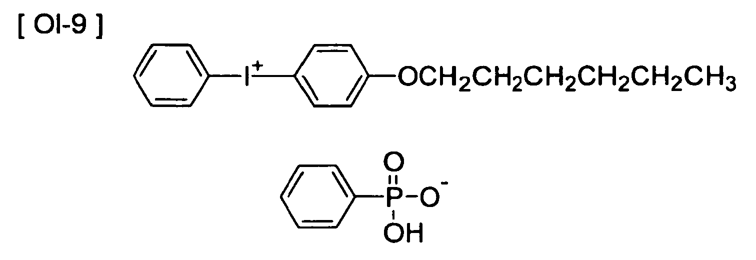

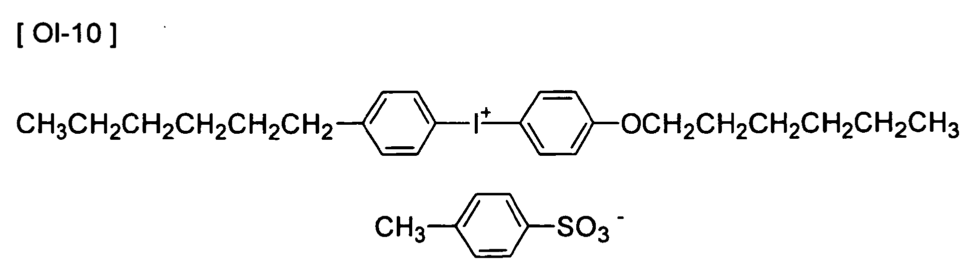

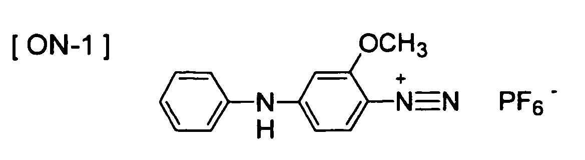

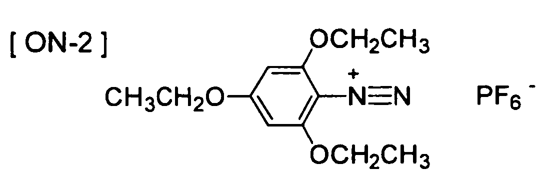

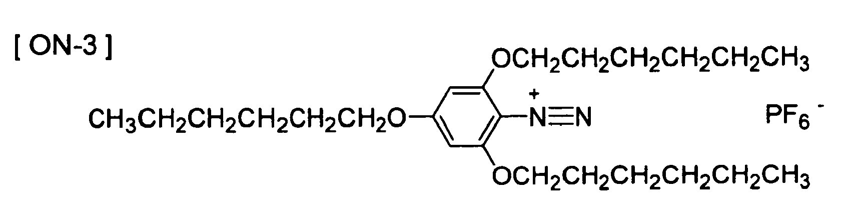

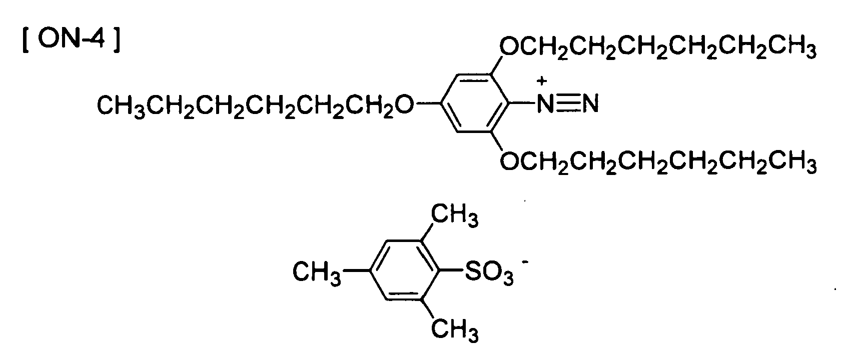

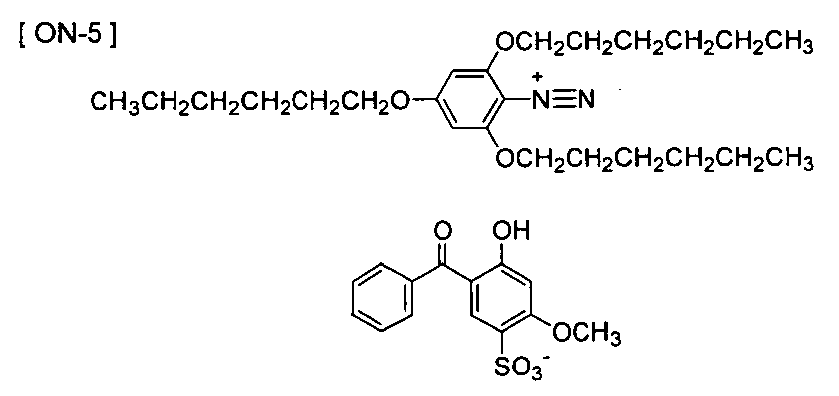

Specific examples of the onium salts preferably used in the invention as the polymerization initiator (radical generator) include those described in JP-A No. 2001-133696.

The polymerization initiator (radical generator) used in the invention preferably has a maximum absorption wavelength of 400 nm or less and more preferably 360 nm or less. By shortening the absorption wavelength into the ultraviolet region in this manner, it becomes possible to handle the planographic printing plate precursor under white light.

The total amount of the polymerization initiators according to the invention contained is preferably 0.1 to 50%, more preferably 0.5 to 30%, and particularly preferably 1 to 20% by mass with respect to the total solid contents in the photosensitive layer, from the viewpoints of sensitivity and stains generated on nonimage portion during printing.

In the invention, the polymerization initiators may be used alone or in combination of two or more. For example, if two or more polymerization initiators are used in combination, only preferable sulfonium salt polymerization initiators may be used, or alternatively, a sulfonium salt polymerization initiator and other polymerization initiators may be used combinedly.

When a sulfonium salt polymerization initiator and another polymerization initiator are used in combination, the ratio (mass ratio) is preferably 100/1 to 100/50 and more preferably 100/5 to 100/25.

The polymerization initiator and another component may be added to the same layer or to different layers separately.

Use of a high-sensitivity sulfonium salt polymerization initiator preferable as polymerization initiator in the photosensitive layer according to the invention allows efficient progress of the radical polymerization reaction and formation of an image portion extremely higher in strength. Accordingly, it also allows production of a planographic printing plate higher in image-portion strength, in combination with the high oxygen-blocking function described below of the protective layer, and consequently further increase in printing durability. In addition, the sulfonium salt polymerization initiator, which is superior in storability, has the advantage that undesirable polymerization reaction is effectively inhibited also when the planographic printing plate precursor produced is stored.

### (Polymerizable compound)

The polymerizable compound for use in the invention is an addition-polymerizable compound having at least one ethylenic unsaturated double bond, and is selected from compounds having at least one, preferably two or more ethylenic unsaturated bonds. These compounds are well known in the art, and any one thereof may be used without restriction in the invention. These compounds are present in various chemical forms, for example, as monomer, prepolymers such as dimer, trimer and oligomer or the mixture thereof, the copolymers thereof. Examples of the monomers and the copolymers include unsaturated carboxylic acids (e.g., acrylic acid, methacrylic acid, itaconic acid, crotonic acid, isocrotonic acid, maleic acid, etc.) and the esters and amides thereof, and preferable examples include esters of an unsaturated carboxylic acid and an aliphatic polyvalent alcohol compound, and amides of an unsaturated carboxylic acid and an aliphatic polyvalent amine compound. Also preferably used are addition reaction products from an unsaturated carboxylic acid ester or amides having a nucleophilic substituent such as hydroxyl group, amino group, mercapto group and a monofunctional or multifunctional isocyanates or epoxy compound; and dehydration condensation products from a monofunctional or multifunctional carboxylic acid. In addition, preferable are addition products from an unsaturated carboxylic acid ester or amides having an electrophilic substituent such as an isocyanate group, epoxy group and a monofunctional or multifunctional alcohol, amine, or thiol; and substitution products from a unsaturated carboxylic acid ester or amide having a nonmagnetic substituent such as a halogen group, tosyloxy group and a monofunctional or multifunctional alcohol, amine, or thiol. Further, it is possible to use compounds wherein the unsaturated carboxylic acid above is replaced by an unsaturated phosphonic acid, styrene, vinyl ether.

Specific examples of the monomers for the esters from an aliphatic polyvalent alcohol compound and an unsaturated carboxylic acid include acrylic esters such as ethylene glycol diacrylate, triethylene glycol diacrylate, 1,3-butanediol diacrylate, tetramethylene glycol diacrylate, propylene glycol diacrylate, neopentylglycol diacrylate, trimethylol propane triacrylate, trimethylol propane tri(acryloyloxypropyl)ether, trimethylol ethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol haxaacrylate, sorbitol triacrylate, sorbitol tetraacrylate, sorbitol pentaacrylate, sorbitol haxaacrylate, tri(acryloyloxyethyl)isocyanurate, polyester acrylate oligomers; methacrylic esters such as tetramethylene glycol dimethacrylate, triethylene glycol dimethacrylate, neopentylglycol dimethacrylate, trimethylol propane trimethacrylate, trimethylol ethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis(p-(3-methacryloxy-2-hydroxy propoxy)phenyl)dimethyl methane, bis-(p-(methacryloxyethoxy)phenyl)dimethyl methane ; itaconic acid esters such as ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate; crotonic acid esters such as ethylene glycol dicrotonate, tetramethylene glycol dicrotonate, pentaerythritol dicrotonate, sorbitol tetradicrotonate; isocrotonic acid esters such as ethylene glycol diisocrotonate, pentaerythritol diisocrotonate, sorbitol tetraisocrotonate; and maleic acid esters such as ethylene glycol dimaleate, triethylene glycol dimaleate, pentaerythritol dimaleate, sorbitol tetramaleate.

Other examples of the esters include aliphatic alcohol-based esters described in JP-B Nos. 46-27926 and 51-47334, and JP-A No. 57-196231; compounds having an aromatic skeleton described in JP-A Nos. 59-5240, 59-5241, and 2-226149; compounds having an amino group described in JP-A No. 1-165613. Further, the above ester monomers may also be used as a mixture.

Specific examples of the monomers for the amides from an aliphatic polyvalent amine compound and an unsaturated carboxylic acid include methylene bis-acrylamide, methylene bis-methacrylamide, 1,6-hexamethylene bis-acrylamide, 1,6-hexamethylene bis-methacrylamide, diethylenetriamine trisacrylamide, xylylene bisacrylamide, xylylene bismethacrylamide. Examples of other preferable amide-based monomers include compounds having a cyclohexylene structure described in JP-B No. 54-21726.

In addition, urethane-based addition-polymerizable compounds produced by addition reaction of an isocyanate and a hydroxyl group-containing compounds are also preferable, and specific examples thereof include vinyl urethane compounds containing two or more polymerizable vinyl groups described in JP-B No. 48-41708, which are prepared by reacting a polyisocyanate compound having two or more isocyanate groups in the molecule with a vinyl monomer containing the hydroxyl group represented by the following Formula.

CH₂=C(R^{a})COOCH₂CH(R^{b})OH Formula

(wherein, R^{a} and R^{b} each represent H or CH₃.)

Additionally, urethane acrylates described in JP-A No. 51-37193, and JP-B Nos. 2-32293 and 2-16765; and urethane compounds having an ethylene oxide-based main chain described in JP-B Nos. 58-49860, 56-17654, 62-39417, and 62-39418 are also preferable. Further, use of the addition-polymerizable compounds having an amino structure or a sulfide structure in the molecule described in JP-ANos. 63-277653, 63-260909, and 1-105238 allows production of photopolymerizable composition extremely superior in sensitization speed.

Other examples thereof include polyester acrylates described in JP-A No. 48-64183, and JP-B Nos. 49-43191 and 52-30490, multifunctional acrylates and methacrylates obtained by reacting an epoxy resin with a (meth)acrylic acid . The other examples include particular unsaturated compound described in JP-B Nos. 46-43946, 1-40337, 1-40336, vinyl phosphonic acid compounds described in JP-A No. 2-25493. In some cases, compounds having a perfluoroalkyl group described in JP-ANo. 61-22048 are preferably used. In addition, photo-curing monomers and oligomers described in J. Adhesion Soc. Jpn, vol. 20, No. 7, pp. 300 to 308 (1984) may also be used.

Detailed conditions of using these addition-polymerizable compounds, for example in the structure, the compound number, and the use amount, may be determined arbitrarily according to the desired final performance. For example, the compounds are selected as follows: A structure having more unsaturated groups per molecule is preferable, and thus divalent or higher-valent compounds are preferable from the point of sensitization speed. In addition, trivalent or higher-valent compounds are preferable for increasing the strength of image portion, i.e., cured film. Further, it is effective to use additionally a compound different in valency and polymerizable group (e.g., acrylic ester, methacrylic ester, styrene-based compounds, vinylether-based compounds), for adjusting both the photosensitivity and the strength of the resulting image portion. A high-molecular weight compound or a more hydrophobic compound is advantageous in sensitization speed and film strength, but often disadvantageous in development speed and in causing precipitation in the developing solution. Further, compatibility with other components (e.g., binder polymer, initiator, coloring agent, etc.) and dispersibility in photosensitive layer are also important factors in selecting or using the addition polymerization compound, and for example, it is sometimes possible to increase the compatibility by using a low-purity compound or in combination of two or more.

In addition, a compound in the particular structure may be selected for use in the planographic printing plate precursor according to the invention, for the purpose of increasing the adhesiveness to the support, protective layer.

The content of the addition-polymerizable compound in the photosensitive layer composition is preferably in the range of 5 to 80% and more preferably in the range of 40 to 75% by mass with respect to the solid contents in the photosensitive layer composition, from the viewpoints of sensitivity, phase separation, adhesiveness of photosensitive layer, as well as precipitation of developing solution.

These polymerizable compounds may be used alone or in combination of two or more. In addition, the structure, composition, and addition amount of the addition-polymerizable compound may be selected arbitrarily, considering the extent of polymerization inhibition by oxygen, resolution, fog, change in refractive index, surface adhesiveness, and others. Further, the planographic printing plate precursor according to in the invention may have other layers such as undercoat and overcoat.

### (Binder polymer)

The binder polymer used in the invention is added for the purpose of increasing the layer property, and any polymer may be used if it functions to improve the layer property. Among many polymers, binder polymers preferable in the invention are, for example, binder polymers having a repeating unit represented by the following Formula (i). Hereinafter, the binder polymers having the repeating unit represented by Formula (i) will be referred to as "particular binder polymers" and described in detail. 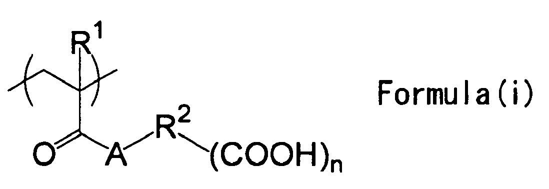 (in Formula (i), R¹ represents a hydrogen atom or a methyl group; R² represents a connecting group consisting of 2 or more atoms selected from the group consisting of carbon atom, hydrogen atom, oxygen atom, nitrogen atom, and sulfur atom and having a total number of atoms of 2 to 82; A represents an oxygen atom or -NR³-; R³ represents a hydrogen atom or a monovalent hydrocarbon group having 1 to 10 carbon atoms; and n denotes an integer of from 1 to 5)

R¹ in Formula (i) represents a hydrogen atom or a methyl group, and preferably a methyl group.

The connecting group represented by R² in Formula (i) is a group containing two or more atoms selected from the group consisting of carbon atom, hydrogen atom, oxygen atom, nitrogen atom, and sulfur atom and having a total atom number of 2 to 82, preferably 2 to 50, and more preferably 2 to 30. The total atom number is the number of atoms including the atoms of substituent when the group has a substituent. More specifically, the number of the atoms constituting the main chain of connecting group represented by R² is preferably 1 to 30, more preferably 3 to 25, and still more preferably 4 to 20, and still more preferably 5 to 10. "The main chain of the connecting group" in the invention is an atom or atom group used for connecting A and the terminal COOH group in Formula (i), and in particular, an atom or atomic group constituting a route having the smallest number of atoms used if there are multiple routes between them. Accordingly, if the connecting group has a cyclic structure, the atom number to be calculated may vary according to the connection site of the terminal group (e.g., o-, m-, p-).

More specific examples thereof include alkylenes, substituted alkylenes, arylenes, substituted arylenes, the (n+1)-valent groups from these groups of which a hydrogen atom on any carbon atom is eliminated, and further, the connecting group may have a structure wherein a multiple number of these groups are bound to each other via an amide or ester bond.

Connecting groups in the chain structure include ethylene, propylene. Examples thereof also include a structure wherein these alkylenes are bound via an ester bond to each other.

Among them, the connecting group represented by R² in Formula (i) is preferably a (n+1)-valent hydrocarbon group having an alicyclic structure of 3 to 30 carbons. More specific examples thereof include (n+1)-valent hydrocarbon groups, prepared by removing (n+1) hydrogen atoms on any carbon atoms of compounds having an alicyclic structure, such as cyclopropane, cyclopentane, cyclohexane, cycloheptane, cyclooctane, cyclodecane, dicyclohexyl, tercyclohexyl, and norbornane, which may be substituted with one or more substituents of any kind. Further, R² preferably has a carbon number of 3 to 30, including the atoms in the substituent.

Any one or more of carbon atoms on the compound having an alicyclic structure may be substituted with a heteroatom selected from a nitrogen atom, oxygen atom, or sulfur atom. From the viewpoint of printing durability, R² is preferably a (n+1)-valent alicyclic hydrocarbon group having 5 to 30 carbons and containing two or more rings, such as fused polycyclic aliphatic hydrocarbons, bridged alicyclic hydrocarbons, spiro aliphatic hydrocarbons, and aliphatic hydrocarbon ring aggregates (multiple rings are connected directly or via a connecting group), which may have an substituent. The number of carbons also includes the carbon atoms in the substituents in this case too.

The connecting group represented by R² is particularly preferably a group having an atom number of the main chain of the connecting group of 5 to 10, and preferably, has a chain structure having an ester bond or the cyclic structure described above.

The substituents that may be introduced to the connecting group represented by R² include monovalent nonmetal atom groups excluding hydrogen, and specific examples thereof include halogen atoms (-F, -Br, -Cl, and -I), hydroxyl group, alkoxy groups, aryloxy groups, mercapto group, alkylthio groups, arylthio groups, alkyldithio groups, aryldithio groups, amino group, N-alkylamino groups, N,N-dialkylamino groups, N-arylamino groups, N,N-diarylamino groups, N-alkyl-N-arylamino groups, acyloxy groups, carbamoyloxy groups, N-alkylcarbamoyloxy groups, N-arylcarbamoyloxy groups, N,N-dialkylcarbamoyloxy groups, N,N-diarylcarbamoyloxy groups, N-alkyl-N-arylcarbamoyloxy groups, alkylsulfoxy groups, arylsulfoxy groups, acylthio groups, acylamino groups, N-alkylacylamino groups, N-aryl acylamino groups, ureide groups, N'-alkylureide groups, N',N'-dialkylureide groups, N'-arylureide groups, N',N'-diarylureide groups, N'-alkyl-N'-arylureide groups, N-alkylureide groups, N-arylureide groups, N'-alkyl-N-alkylureide groups, N'-alkyl-N-arylureide groups, N',N'-dialkyl-N-alkylureide groups, N',N'-dialkyl-N-arylureide groups, N'-aryl-N-alkylureide groups, N'-aryl-N-arylureide groups, N',N'-diaryl-N-alkylureide groups, N',N'-diaryl-N-arylureide groups, N'-alkyl-N'-aryl-N-alkylureide groups, N'-alkyl-N-aryl-N-arylureide groups, alkoxycarbonylamino groups, aryloxycarbonylamino groups, N-alkyl-N-alkoxycarbonylamino groups, N-alkyl-N-aryloxycarbonylamino groups, N-aryl-N-alkoxycarbonylamino groups, N-aryl-N-aryloxycarbonylamino groups, formyl group, acyl groups, carboxyl group and the conjugated base groups, alkoxycarbonyl groups, aryloxy carbonyl groups, carbamoyl groups, N-alkylcarbamoyl groups, N,N-dialkylcarbamoyl groups, N-arylcarbamoyl groups, N,N-diarylcarbamoyl groups, N-alkyl-N-arylcarbamoyl groups, alkylsulfinyl groups, arylsulfinyl groups, alkylsulfonyl groups, arylsulfonyl groups, sulfo group (-SO₃H) and the conjugated base groups, alkoxysulfonyl groups, aryloxysulfonyl groups, sulfinamoyl groups, N-alkylsulfinamoyl groups, N,N-dialkylsulfinamoyl groups, N-arylsulfinamoyl groups, N,N-diarylsulfinamoyl groups, N-alkyl-N-arylsulfinamoyl groups, sulfamoyl groups, N-alkylsulfamoyl groups, N,N-dialkylsulfamoyl groups, N-arylsulfamoyl groups, N,N-diarylsulfamoyl groups, N-alkyl-N-arylsulfamoyl groups, N-acylsulfamoyl groups and the conjugated base groups, N-alkylsulfonylsulfamoyl groups [-SO₂NHSO₂(alkyl)] and the conjugated base groups, N-arylsulfonylsulfamoyl groups [-SO₂NHSO₂ (aryl)] and the conjugated base groups, N-alkylsulfonylcarbamoyl groups [-CONHSO₂(alkyl)] and the conjugated base groups, N- arylsulfonylcarbamoyl groups [-CONHSO₂(aryl)] and the conjugated base groups, alkoxysilyl groups [-Si(O-alkyl)₃], aryloxysilyl groups [-Si(O-aryl)₃], hydroxysilyl group [-Si(OH)₃] and the conjugated base groups, phosphono group [-PO₃H₂] and the conjugated base groups, dialkylphosphono groups [-PO₃(alkyl)₂], diarylphosphono groups [-PO₃(aryl)₂], alkylarylphosphono group [-PO₃(alkyl)(aryl)], monoalkylphosphono groups [-PO₃H(alkyl)] and the conjugated base groups, monoarylphosphono groups [-PO₃H(aryl)] and the conjugated base groups, phosphonooxy group (-OPO₃H₂) and the conjugated base groups, dialkylphosphonooxy groups [-OPO₃(alkyl)₂], diarylphosphonooxy groups [-OPO₃(aryl)₂], alkylarylphosphonooxy groups [-OPO₃(alkyl)(aryl)], monoalkylphosphonooxy groups [-OPO₃H(alkyl)] and the conjugated base groups, monoarylphosphonooxy groups [-OPO₃H(aryl)] and the conjugated base groups, cyano group, nitro group, dialkylboryl groups [-B(alkyl)₂], diarylboryl groups [-B(aryl)₂], alkylarylboryl groups [-B(alkyl)(aryl)], dihydroxyboryl group [-B(OH)₂] and the conjugated base groups, alkylhydroxyboryl groups [-B(alkyl)(OH)] and the conjugated base groups, arylhydroxyboryl groups [-B(aryl)(OH)] and the conjugated base groups, aryl groups, alkenyl groups, alkynyl groups.

In the planographic printing plate precursor according to the invention, a substituents having a hydrogen atom that can form a hydrogen bond and in particular, a substituent having an acidic group that has an acid dissociation constant (pKa) smaller than carboxylic acid are not preferable, as they tend to decrease the printing durability depending on the design of the photosensitive layer. On the other hand, hydrophobic substituents such as halogen atoms, hydrocarbon groups (alkyl group, aryl group, alkenyl group, alkynyl group), alkoxy groups, aryloxy groups are more preferably as they tend to increase the printing durability, and in particular, if the cyclic structure is a monocyclic aliphatic hydrocarbon of six-membered ring or less such as cyclopentane and cyclohexane, the substituent preferably has such a hydrophobic substituent. These substituents may bind to each other or to a substituted hydrocarbon group, forming a ring, and may have additionally a substituent thereon.

When A in Formula (i) is NR³-, R³ represents a hydrogen atom or a monovalent hydrocarbon group having 1 to 10 carbons. The monovalent hydrocarbon groups having 1 to 10 carbons represented by R³ above include alkyl groups, aryl groups, alkenyl groups, and alkynyl groups.

Specific examples of the alkyl groups include straight-chain, branched-chain, or cyclic alkyl groups having 1 to 10 carbons such as methyl group, ethyl group, propyl group, butyl group, pentyl group, hexyl group, heptyl group, octyl group, nonyl group, decyl group, isopropyl group, isobutyl group, sec-butyl group, tert-butyl group, isopentyl group, neopentyl group, 1-methylbutyl group, isohexyl group, 2-ethylhexyl group, 2-methylhexyl group, cyclopentyl group, cyclohexyl group, 1-adamantyl group, 2-norbornyl group.

Specific examples of the aryl groups include aryl groups having 1 to 10 carbons such as phenyl group, naphthyl group, and indenyl group; and heteroaryl groups having 1 to 10 carbons and containing a hetero atom selected from the group consisting of nitrogen atom, oxygen atom and sulfur atom such as furyl group, thienyl group, pyrrolyl group, pyridyl group, and quinolyl group.

Specific examples of the alkenyl groups include straight-chain, branched-chain, or cyclic alkenyl groups having 1 to 10 carbons such as vinyl group, 1-propenyl group, 1-butenyl group, 1-methyl-1-propenyl group, 1-cyclopentenyl group, and 1-cyclohexenyl group.

Specific examples of the alkynyl groups include alkynyl groups having 1 to 10 carbons such as ethynyl group, 1-propynyl group, 1-butynyl group, and 1-octynyl group. The substituents, which R3 may have, are the same as the substituents which R² may have. However, the number of R³ carbons is 1 to 10, including the number of carbons in the substituent.

A in Formula (i) is preferably an oxygen atom or -NH-, as it is easier to produce.

In Formula (i), n denotes an integer of 1 to 5, and preferably 1 from the viewpoint of printing durability.

Preferable specific examples of the repeating unit represented by Formula (i) will be listed below, however the invention is not limited by these examples.

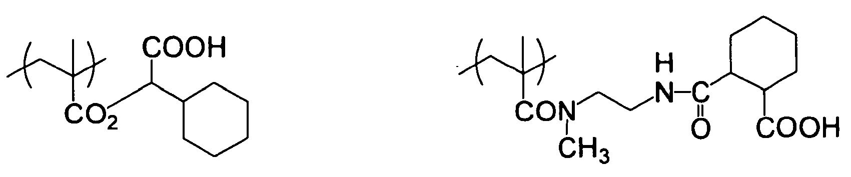

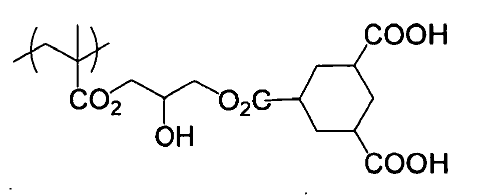

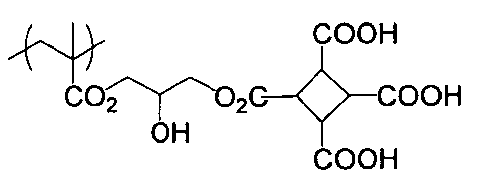

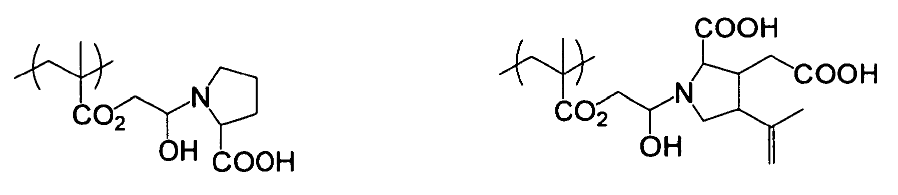

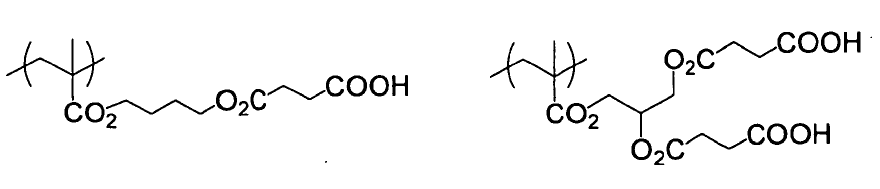

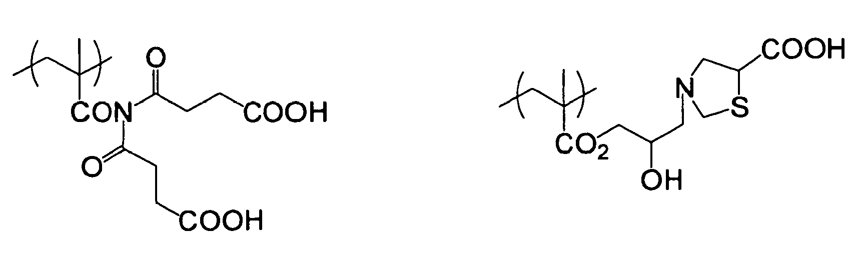

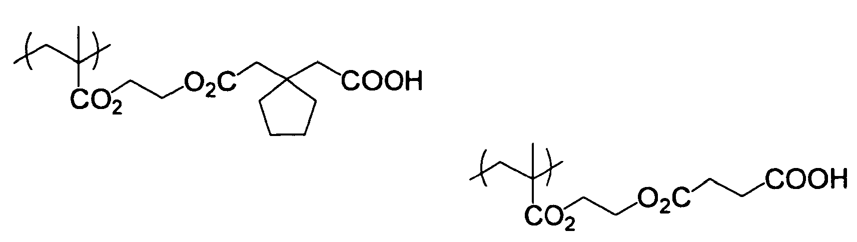

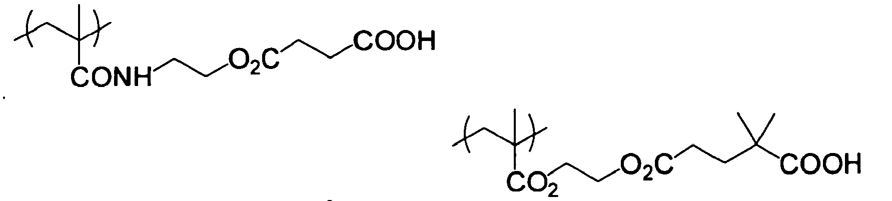

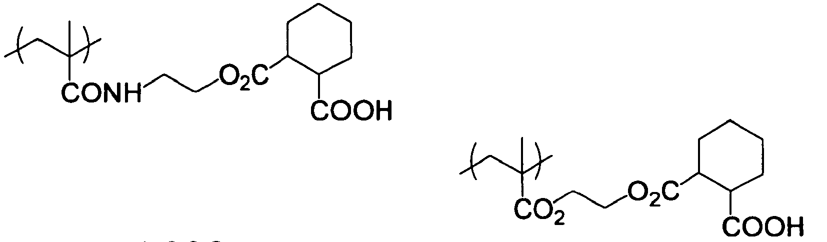

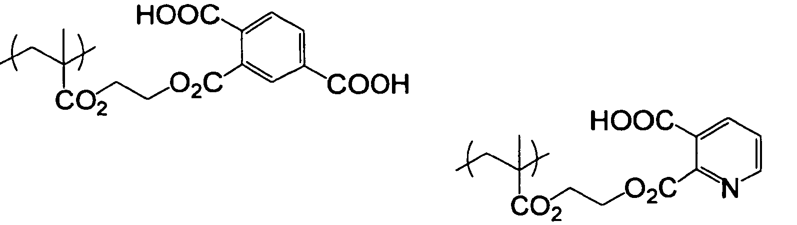

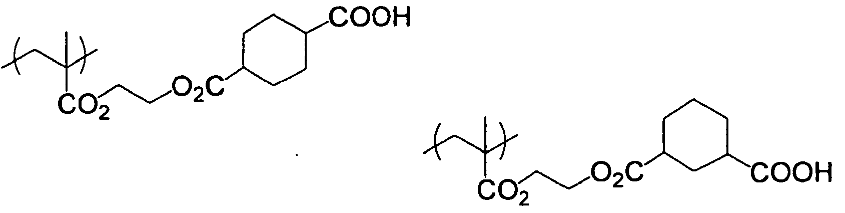

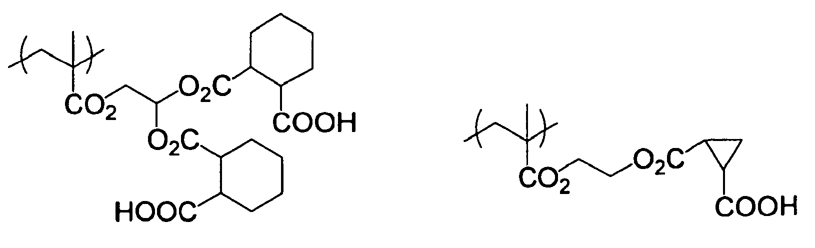

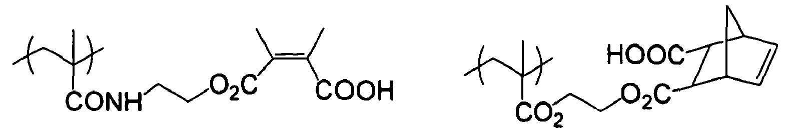

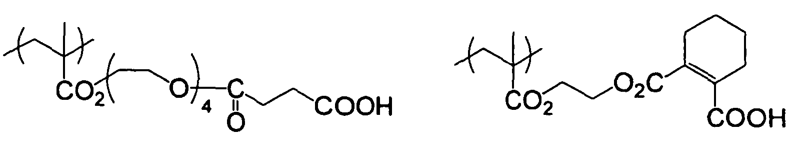

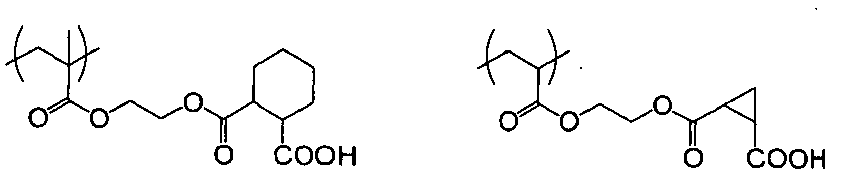

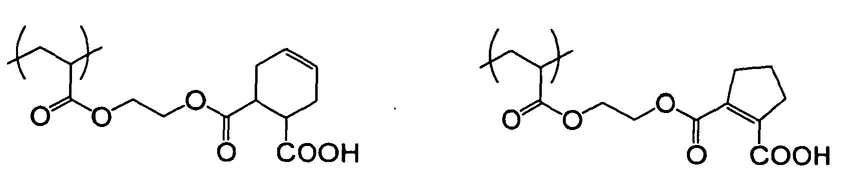

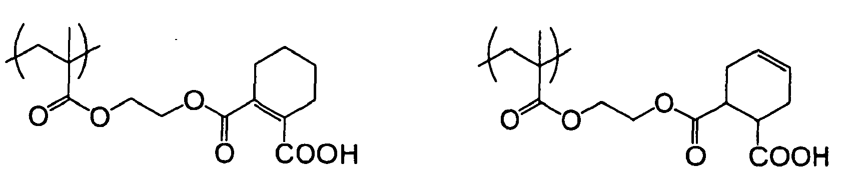

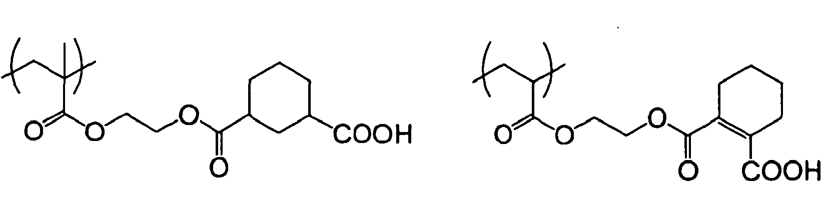

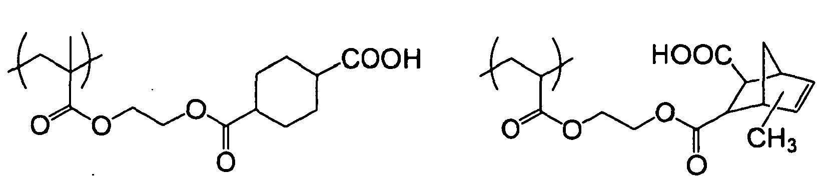

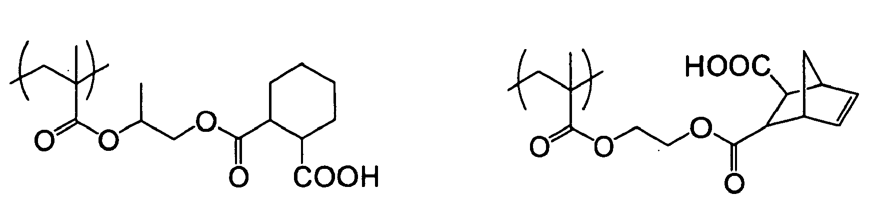

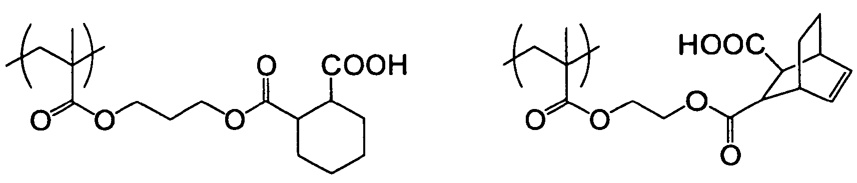

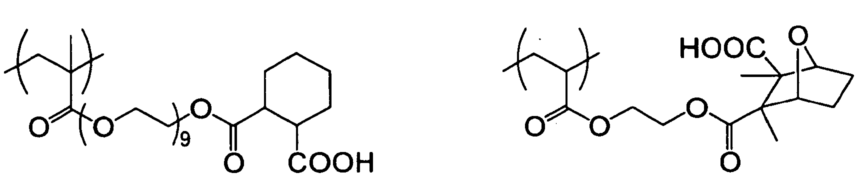

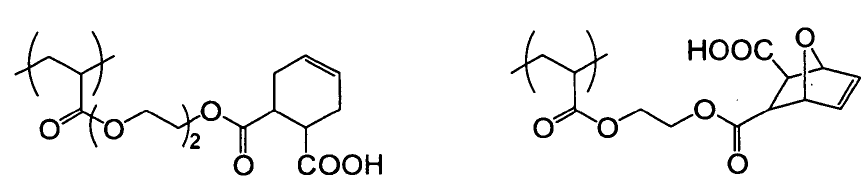

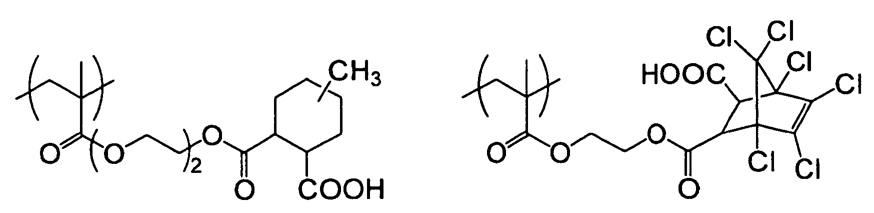

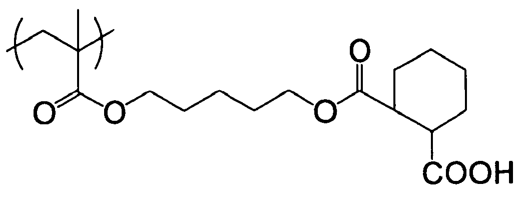

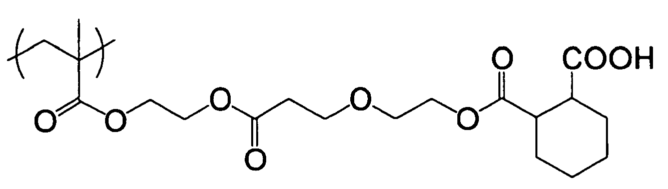

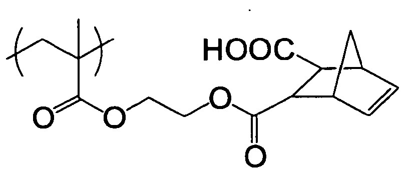

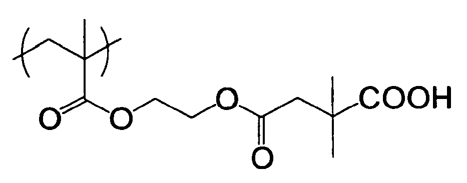

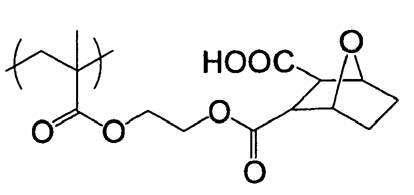

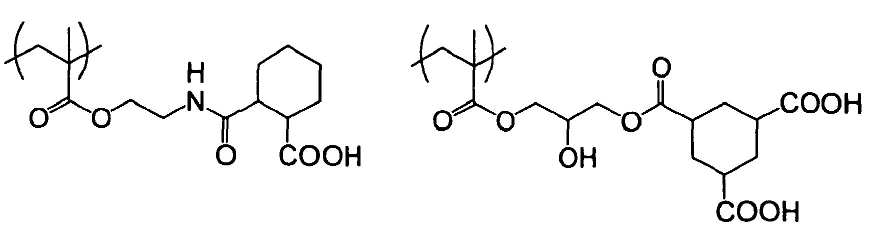

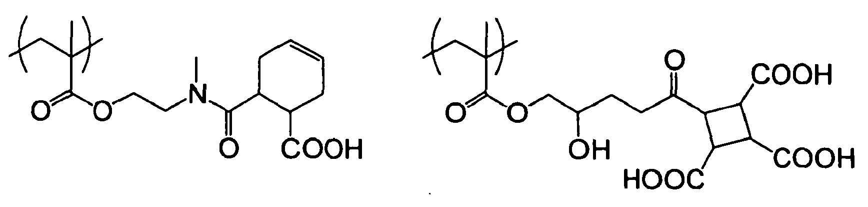

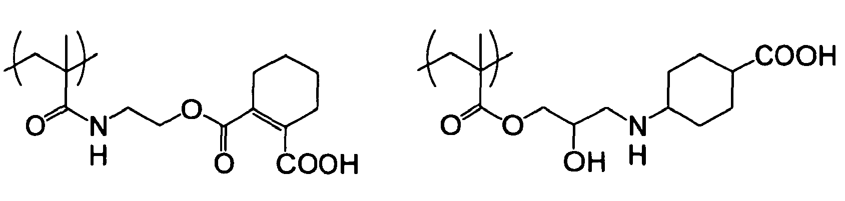

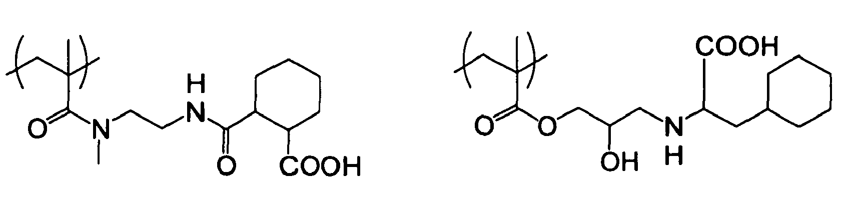

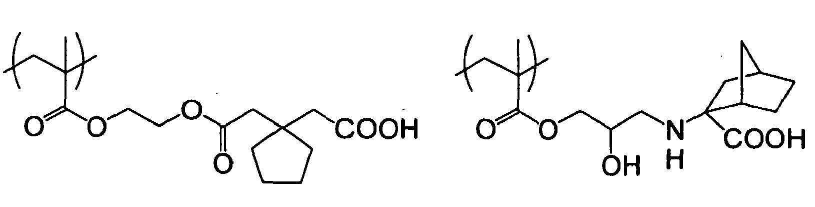

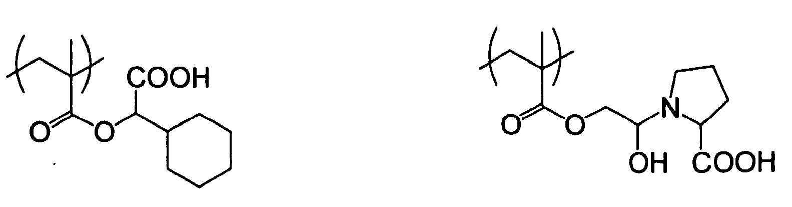

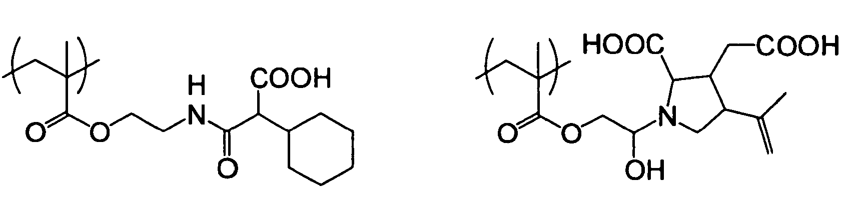

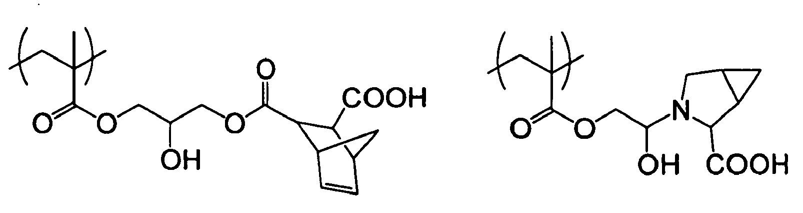

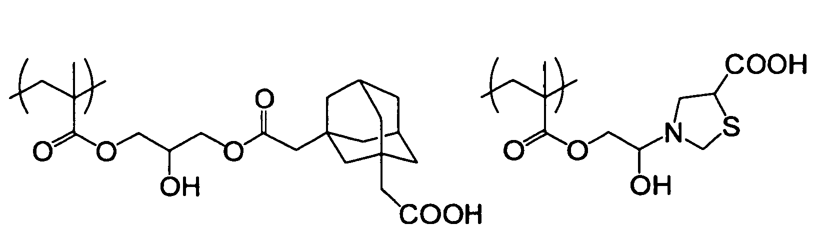

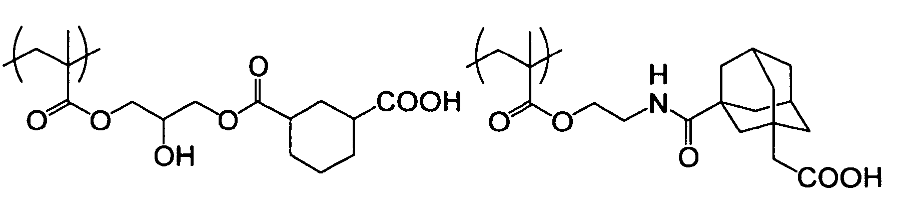

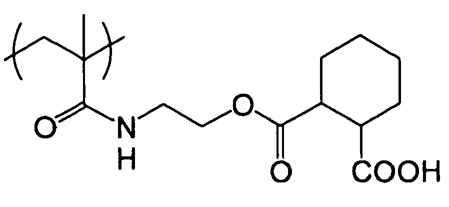

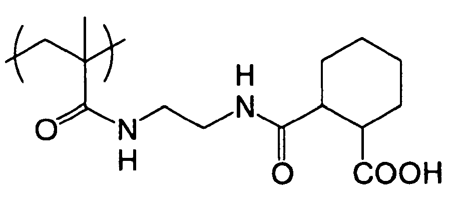

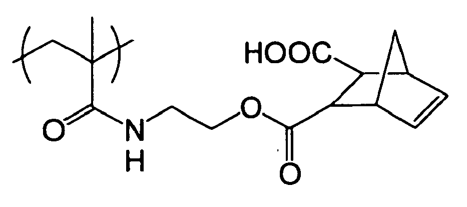

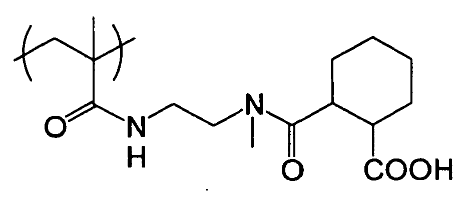

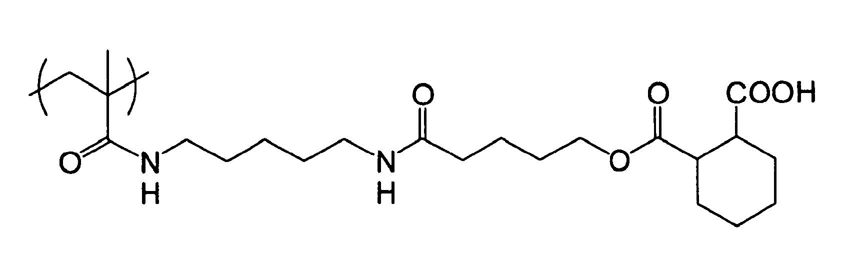

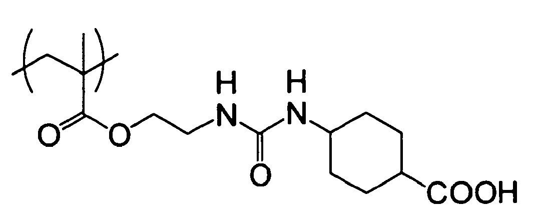

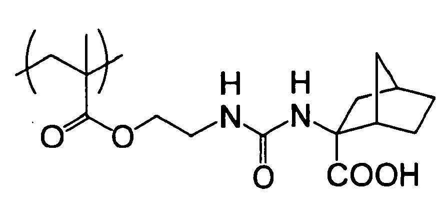

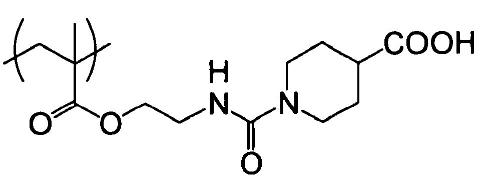

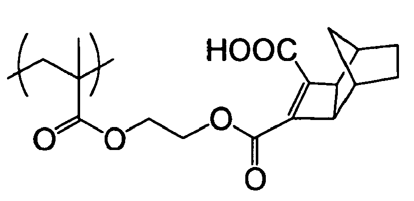

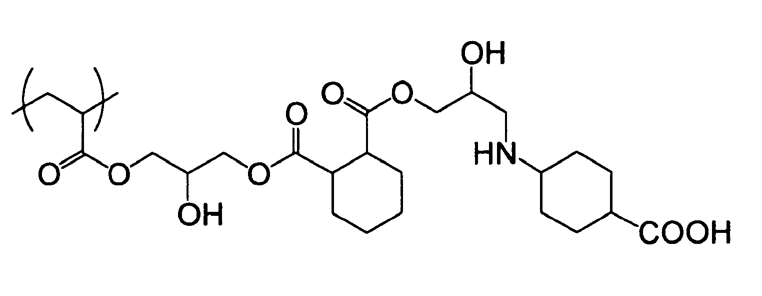

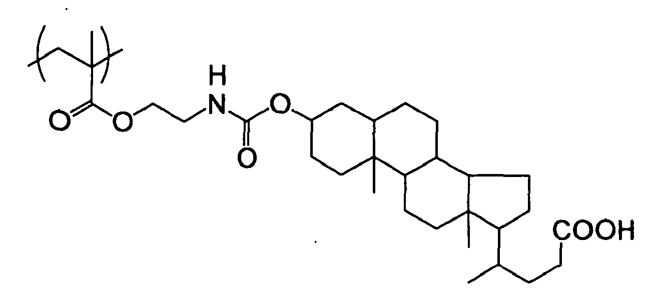

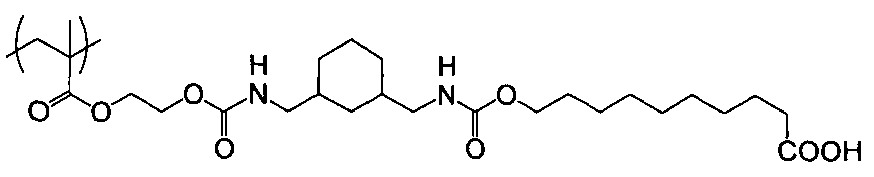

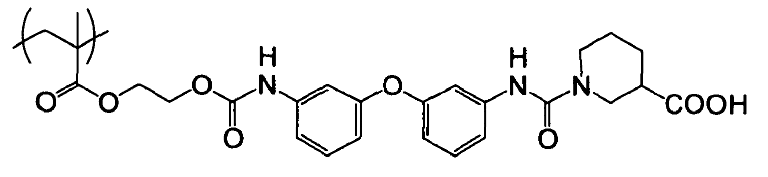

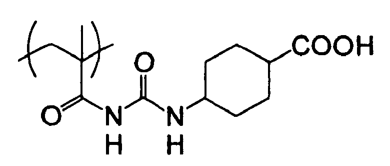

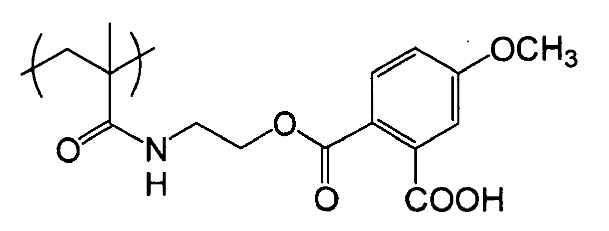

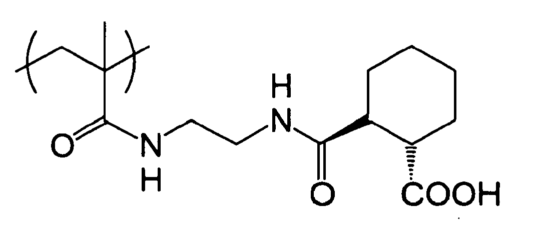

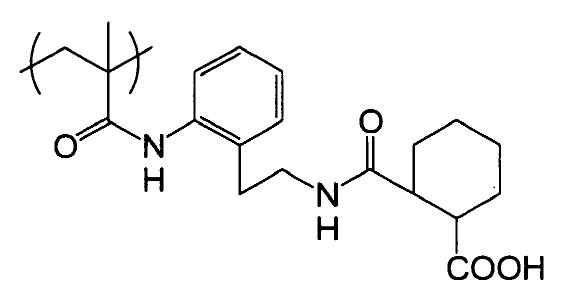

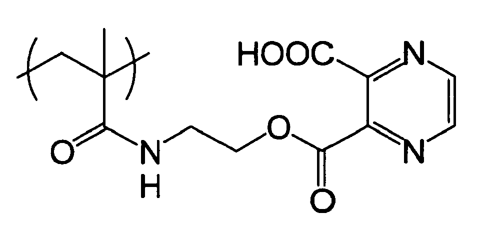

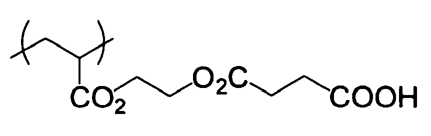

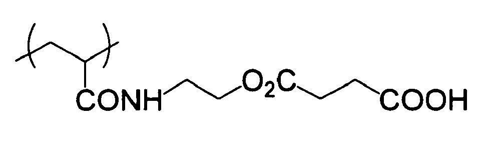

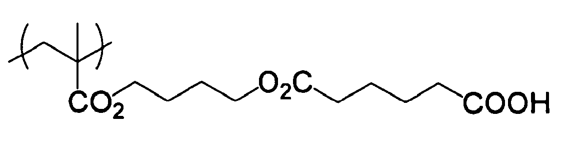

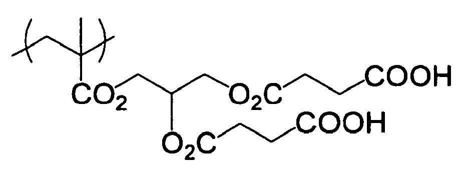

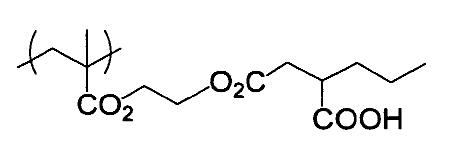

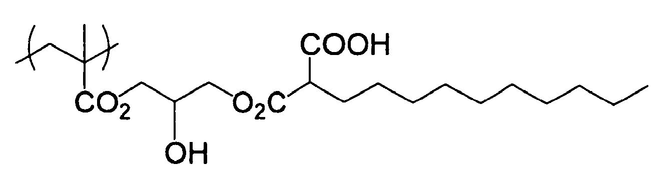

The repeating units represented by Formula (i) may be present alone or in combination of two or more in the binder polymer. The particular binder polymer according to the invention may be a polymer consisting only of the repeating unit represented by Formula (i), but is used normally as a copolymer in combination with other copolymerization components. The total content of the repeating unit represented by Formula (i) in the copolymer may be decided suitably according to the structure and the design of the photosensitive layer composition, but is preferably in the range of 1 to 99 mole%, more preferably 5 to 40 mole%, and still more preferably 5 to 20 mole% with respect to the total number of moles.

Any known radical polymerizable monomers may be used without restriction as the copolymerization component for the copolymer. Specifically, such monomers include those described in "Polymer Data Handbook -Basic- (Soc. Polymer Science, Japan Ed., Baihukan, 1986)". The copolymerization components may be used alone or in combination of two or more.

The molecular weight of the particular binder polymer according to the invention is determined suitably according to the desirable image-forming ability and printing durability. The molecular weight is preferably in the range of 2,000 to 1,000,000, more preferably 5,000 to 500,000, and still more preferably 10,000 to 200,000.

The binder polymer used in the invention may be a single particular binder polymer or a mixture with one or more other binder polymers. The binder polymer used in combination is added in an amount in the range of 1 to 60% by mass, preferably 1 to 40% by mass, still more preferably 1 to 20% by mass with respect to the total mass of the binder polymer components. Any known polymers may be used as the binder polymer without restriction, and specific examples thereof include acryl main-chain binders and urethane binders.

The total amount of the particular binder polymer and the binder polymer for use in combination in the photosensitive layer composition may be decided suitably, but is normally in the range of 10 to 90%, preferably 20 to 80%, and still more preferably 30 to 70% by mass with respect to the total mass of the nonvolatile components in the photosensitive layer composition.

The acid value (meg/g) of these binder polymers is preferably in the range of 2.00 to 3.60.

### -Other binder polymer for use in combination-

The particular binder polymer and the other binder polymer for use in combination each are preferably a binder polymer having a free radical polymerizable group.

The radical polymerizable group is not particularly limited, if it can polymerize by free radicals, and examples thereof include α-substituted methylacryl groups [-OC(=O)-C(-CH₂Z)=CH₂, Z=hydrocarbon group starting from a hetero atom], acryl group, methacryl group, allyl group, styryl group, and among them, acryl group and methacryl group are preferable.

The content of the radical polymerizable group in the binder polymer (content of radical polymerizable unsaturated double bond determined by iodimetry) is preferably 0.1 to 10.0 mmol, more preferably 1.0 to 7.0 mmol, most preferably 2.0 to 5.5 mmol per g of binder polymer, from the viewpoints of sensitivity and storage stability.

In addition, the other binder polymer for use in combination preferably has additionally an alkali-soluble group. The content of the alkali-soluble group in the binder polymer (acid value by neutralization titration) is preferably 0.1 to 3.0 mmol, more preferably 0.2 to 2.0 mmol, and most preferably 0.45 to 1.0 mmol per g of binder polymer, from the viewpoints of the precipitation of development scum and the printing durability.

The weight-average molecular weight of the binder polymer is preferably in the range of 2,000 to 1,000,000, more preferably 10,000 to 300,000, and most preferably 20,000 to 200,000 from the viewpoints of film property (printing durability) and the solubility in coating solvent.

The glass transition temperature (Tg) of the binder polymer is preferably in the range of 70 to 300°C, more preferably 80 to 250°C, and still more preferably 90 to 200°C, from the viewpoints of storage stability, printing durability, and sensitivity.

The binder polymer preferably has an amide group or an imide group in the molecule, and in particular, methacrylamide or a methacrylamide derivative is preferable for raising the glass transition temperature of binder polymer.

### (Other component)

The photosensitive layer of the planographic printing plate precursor according to the invention may contain, in addition to the primary components above, other components suitable for application, production method, and others additionally. Hereinafter, examples of the preferable additives will be described.

### - Colorant-

A dye or pigment may be added to the photosensitive layer of the planographic printing plate precursor according to the invention for the purpose of coloring the layer.

It is thus possible to improve so-called plate-checking properties such as the visibility of image after platemaking and the applicability for image densitometer. Specific examples of the coloring agents include pigments such as phthalocyanine-based pigments, azo-based pigments, carbon black, and titanium oxide; dyes such as ethyl violet, crystal violet, azo-based dyes, anthraquinone-based dyes, and cyanine-based dye; and among them, cationic dyes are preferable.

The amount of the dyes and pigments added as coloring agent is preferably about 0.5 to 5% by mass, with respect to the total amount of nonvolatile components in the photosensitive layer composition.

### - Polymerization inhibitor-

It is preferable to add a trace amount of thermal polymerization inhibitor for prevention of undesirable thermal polymerization of the polymerizable compound, i.e., a compound having a polymerizable ethylenic unsaturated double bond, to the photosensitive layer according to in the invention. Suitable thermal polymerization inhibitors include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), N-nitrosophenylhydroxyamine cerous salt. The amount of the thermal polymerization inhibitor added is preferably about 0.01 to 5% by mass with respect to the mass of nonvolatile components in the photosensitive layer composition. In addition, for prevention of the polymerization inhibition by oxygen, a higher fatty acid derivative such as behenic acid or behenic acid amide may be added as needed and localized on the surface of the layer in the drying step after application. The amount of the higher fatty acid derivative added is preferably about 0.5 to 10% by mass with respect to the nonvolatile components in the photosensitive layer composition.

### -Other additives-

In addition, other additives known in the art, including inorganic fillers and other plasticizers for improvement in the physical properties of hardened films and sensitizing agents for improvement in inking property of photosensitive layer surface, may be added to the photosensitive layer according to the invention. Examples of the plasticizers include dioctyl phthalate, didodecyl phthalate, triethylene glycol dicaprylate, dimethylglycol phthalate, tricresyl phosphate, dioctyl adipate, dibutyl sebacate, triacetylglycerin, and the plasticizer can be added normally in an amount of 10% by mass or less with respect to the total mass of the binder polymers and addition-polymerizable compounds.

It is also possible to add an UV initiator or a heat cross-linking agent to the photosensitive layer according to in the invention, for the purpose of improving the film strength (printing durability) described below by strengthening the effects of heating and exposure after development.

### (Support)

A support hydrophilized as described below is used as the support according to the invention. Preferable examples of the supports include paper, polyester films and aluminum plates; and among them, aluminum plates, which are superior in dimensional stability and cheaper that gives a surface superior in hydrophilicity and strength by surface treatment as needed, are particularly preferable. The composite sheet of a polyethylene terephthalate film and an aluminum sheet described in JP-B No. 48-18327 is also preferable.

In the invention, the aluminum plate most suitable as the support is a metal plate containing aluminum as the primary component higher in dimensional stability, and is selected from, in addition to pure aluminum plates, plastic films or papers laminated or vapor-deposited with aluminum or an aluminum alloy containing aluminum as the primary component and a trace amount of foreign components or aluminum. In the description below, a support of the aluminum or aluminum alloy above will be named generically aluminum support. The foreign components contained in the aluminum alloy include silicon, iron, manganese, copper, magnesium, chromium, zinc, bismuth, nickel, titanium, and the content of the foreign components in the alloy is 10% by mass or less. Although the most preferable aluminum in the invention is pure aluminum, the aluminum plate may contain a trace amount of foreign elements, as it is difficult to prepare completely pure aluminum due to the problems in refining processes. As described above, the components of the aluminum plates to be used in the invention may not be particularly specified, and any one of the aluminum plates known and used in the art, for example, those applicable for JIS A1050, A1100, A3103, and A3005, may be used arbitrarily.

The thickness of the aluminum support for use in the invention is about 0.1 mm to 0.6 mm. The thickness may be suitably changed according to the size of printing machine, the dimension of printing plate, and the needs of user.

Such an aluminum support is hydrophilized by surface treatment as will be described below.

### (Surface-roughening treatment)

Methods for surface roughening include the mechanical surface roughening, chemical etching, and electrolytic graining disclosed in JP-A No. 56-28893. In addition, the methods include mechanical surface roughening methods including an electrochemical surface roughening method of surface roughening electrochemically in a hydrochloric acid or nitric acid electrolyte; a wire brush graining method of scratching the aluminum surface with metal wires; a ball graining method of roughening the aluminum surface with abrasive balls and abrasives; a brush graining method of surface roughening with nylon brushes and abrasives, and the surface roughening methods may be used alone or in combination. Among the surface roughening methods above, preferable is the electrochemical method of chemically surface roughening in a hydrochloric acid or nitric acid electrolyte, and the suitable amount of anodic electric current is in the range of 50 to 400 C/dm². More specifically, the alternate current and/or direct current electrolysis is preferably carried out in an electrolyte containing 0.1 to 50% hydrochloric or nitric acid under the condition of a temperature of 20 to 80°C, a time period of 1 second to 30 minutes, and an electric current density of 100 to 400 C/dm².

The aluminum support processed in the surface roughening treatment may further chemically etched in an acid or alkali. Preferable examples of the etching agents include sodium hydroxide, sodium carbonate, sodium aluminate, sodium metasilicate, sodium phosphate, potassium hydroxide, lithium hydroxide, and the preferable ranges of the concentration and the temperature are respectively 1 to 50%, and 20 to 100°C. After etching, the support is washed with an acid for removal of the stain remaining on the surface (smut). Acids frequently used include nitric acid, sulfuric acid, phosphoric acid, chromic acid, hydrofluoric acid, borofluoric acid. In particular, preferable methods for removal of the smuts after electrochemical surface roughening treatment include the method described in JP-A No. 53-12739 wherein the surface is brought into contact with 15 to 65% by mass sulfuric acid at a temperature of 50 to 90°C, and the method described in JP-B 48-28123 wherein the surface is alkaline etched. The methods and conditions are not particularly limited, if the surface roughness of the treated surface Ra is about 0.2 to 0.5 µm after the treatment.

### (Anodizing process)

Aluminum support whereon an oxide layer is formed in the above manner is subjected to an anodizing treatment.

In the anodizing treatment, aqueous solution of sulfuric acid, phosphoric acid, oxalic acid, and boric acid/sodium borate are used alone or in combination of plural solutions as the primary component of the electrolytic solution. The electrolyte solution may of course contain other components commonly found at least in A1 alloy plates, electrodes, tap water, underground water. In addition, the second and third components may be added. The second and third components include, for example, cations including metal ions such as Na, K, Mg, Li, Ca, Ti, Al, V, Cr, Mn, Fe, Co, Ni, Cu, and Zn, and ammonium ion; and anions such as nitrate, carbonate, chloride, phosphate, fluoride, sulfite, titanate, silicate, and borate ions, and may be contained at a concentration of about 0 to 10,000 ppm. The condition of the anodizing process is not particularly limited, however the support is preferably processed in a direct current or alternate current electrolysis under the condition of a concentration in the range of 30 to 500 g/L, a treatment solution temperature of 10 to 70°C, and an electric current density of 0.1 to 40 A/m². The thickness of the anodic oxide film formed is in the range of 0.5 to 1.5 µm, and preferably in the range of 0.5 to 1.0 µm. The anodic oxidation condition is preferably selected so that the diameter of the micropores present in the anodic oxide film of the support prepared as described above becomes 5 to 10 nm and the pore density in the range of 8 × 10¹⁵ to 2 × 10¹⁶ pieces/m².

Any method known in the art may be used for the hydrophilizing treatment of the support surface. Particularly preferable is a hydrophilizing treatment by using a silicate salt or polyvinyl phosphonic acid. The film is preferably formed at an amount of 2 to 40 mg/m², more preferably 4 to 30 mg/m² as Si or P element. The coating amount can be determined by fluorescent X-ray analysis.

The hydrophilizing treatment above can be carried out, for example, by immersing an aluminum support whereon an anodic oxide film is formed in an aqueous solution containing an alkali metal silicate salt or polyvinylphosphonic acid at a concentration of 1 to 30%, preferably 2 to 15% by mass, and having a pH at 25°C in the range of 10 to 13 at a temperature of 15 to 80°C for 0.5 to 120 seconds.

The alkali metal silicate salts used for the hydrophilizing treatment include sodium silicate, potassium silicate, lithium silicate. The hydroxides used for raising the pH of the aqueous alkali metal silicate salt solution include sodium hydroxide, potassium hydroxide, lithium hydroxide. An alkaline earth metal salt or a Group IVB metal salt may be added to the treatment solution. Examples of the alkaline earth metal salts include water-soluble salts, for example, nitric acid salts such as calcium nitrate, strontium nitrate, magnesium nitrate, and barium nitrate, sulfate salts, hydrochloric acid salts, phosphate salts, acetate salts, oxalate salts, borate salts. Examples of the Group IVB metal salts include titanium tetrachloride, titanium trichloride, titanium potassium fluoride, titanium potassium oxalate, titanium sulfate, titanium tetraiodide, zirconium chloride oxide, zirconium dioxide, zirconium oxychloride, zirconium tetrachloride, and the like.

The alkaline earth metal or Group IVB metal salts may be used alone or in combination of two or more. The preferable content of these metal salts is in the range of 0.01 to 10% and more preferably in the range of 0.05 to 5.0% by mass. Alternatively, the silicate electrodeposition described in U.S. Patent No. 3,658,662 is also effective. Further, combination of the support previously subjected to an electrolytic graining and the anodizing and hydrophilizing treatments as disclosed in JP-B No. 46-27481, and JP-A Nos. 52-58602 and 52-30503 is also useful as the surface treatment.

### (Preparation of planographic printing plate precursor)

The planographic printing plate precursor according to the invention characteristically has the protective layer described above as the top layer, and may have a photosensitive layer and the protective layer, as well as an undercoat layer and others as needed, formed in this order on a support. Such a planographic printing plate precursor can be prepared by applying the coating solutions containing various components described above respectively dissolved in suitable solvents on a support one by one.

In forming a photosensitive layer, the photosensitive layer components are dissolved in an organic solvent, and the resulting photosensitive layer-coating solution is coated on a support or an undercoat layer.

Examples of the solvents for use include acetone, methylethylketone, cyclohexane, ethyl acetate, ethylene dichloride, tetrahydrofuran, toluene, ethylene glycol monomethylether, ethylene glycol monoethylether, ethylene glycol dimethylether, propylene glycol monomethylether, propylene glycol monoethylether, acetylacetone, cyclohexanone, diacetone alcohol, ethylene glycol monomethylether acetate, ethylene glycol ethylether acetate, ethylene glycol monoisopropylether, ethylene glycol monobutylether acetate, 3-methoxypropanol, methoxymethoxyethanol, diethylene glycol monomethylether, diethylene glycol monoethylether, diethylene glycol dimethylether, diethylene glycol diethylether, propylene glycol monomethylether acetate, propylene glycol monoethylether acetate, 3-methoxypropyl acetate, N,N-dimethylformamide, dimethylsulfoxide, γ-butylolactone, methyl lactate, ethyl lactate, and the like. These solvents may be used alone or as mixed. The concentration of the solid content in the photosensitive layer-coating solution is preferably 2 to 50 mass%.

The amount of the photosensitive layer coated on support, which exerts influences mainly on the sensitivity and developing efficiency of photosensitive layer and the strength and printing durability of exposed film, is selected properly according to its application. An excessively smaller coating amount results in insufficient printing durability. Alternatively, an excessively larger coating amount is also unpreferable, because it results in reduction in sensitivity and elongation of exposure and development. The coating amount of the planographic printing plate obtained by the invention is preferably in the range of approximately 0.1 g/m² to approximately 10 g/m², more preferably 0.5 to 5 g/m², by mass after drying.

### (Intermediate layer (undercoat layer))

An intermediate layer (undercoat layer) may be formed between the photosensitive layer and the support in the planographic printing plate precursor according to the invention for improvement in adhesiveness and staining-resistance. Specific examples of the intermediate layers include those described in JP-B No. 50-7481; JP-A Nos. 54-72104, 59-101651, 60-149491, 60-232998, 3-56177, 4-282637, 5-16558, 5-246171, 7-159983, 7-314937, 8-202025, 8-320551, 9-34104, 9-236911, 9-269593, 10-69092, 10-115931, 10-161317,10-260536, 10-282682, 11-84674, 10-69092, 10-115931, 11-38635, 11-38639, 10-282645, 10-301262, 11-24277, 11-109641, 10-319600, 11-84674, 11-327152, 2000-10292, 2000-235254, 2000-352854, 2001-209170, and 11-284091; and others.

### <Platemaking method>

Hereinafter, the platemaking method for the planographic printing plate according to the invention will be described.

The planographic printing plate precursor according to the invention described above is produced characteristically in the steps of placing a stack of planographic printing plate precursors prepared by piling multiple pairs of a protective layer and an aluminum plate with each of the protective layers in contact with the rear surface of an aluminum support within a plate setter, conveying each of the planographic printing plate precursors automatically, irradiating the precursor with a light at a wavelength of 750 to 1,400 nm, and developing the precursor practically without heat treatment under the condition of a traveling speed of 1.25 m/min or more.

The planographic printing plate precursor according to the invention described above can be applied to the plate-making method described above, because adhesiveness between planographic printing plate precursors and generation of scratch on the protective layer are suppressed even when they are stacked without an insert paper in between.

The method of making the planographic printing plate according to the invention, which uses a stack of planographic printing plate precursors without insert paper, eliminates the need for removal of the insert paper and improves the productivity in the platemaking process.

The plate-making method is not only preferable for the planographic printing plate precursor according to the invention above, but may also be applied preferably for the planographic printing plate precursor having a polymerizable negative type photosensitive layer that at least contains an infrared absorbent, a polymerization initiator, and a polymerizable compound and becomes less soluble in alkaline developing solution by exposure to a light at a wavelength of 750 to 1,400 nm. Specifically, the latter precursor has a photosensitive layer containing respective components, the "infrared absorbent, polymerization initiator, and polymerizable compound" described above as the components for the photosensitive layer of the planographic printing plate precursor according to the invention, and the layer may or may not contain a known binder polymer.

In addition, the photosensitive layer to which the method of making the planographic printing plate according to the invention is applied preferably has physical properties of a developing speed of 80 nm/sec or more in an alkaline developing solution at pH 10 to 13.5 in the unexposed area and a permeation speed of the alkaline developing solution into the exposed area at 50 nF/sec or less. The methods described in an application, JP-A No. 2004-65065, filed by the applicant may be used for determining the developing speed of the photosensitive layer in the unexposed area and the permeation speed of the alkaline developing solution into the photosensitive layer after hardening. Any one of ordinary methods may be used for controlling the developing speed of the photosensitive layer in the unexposed area or the permeation speed of the alkaline developing solution into the photosensitive layer after hardening, and typically, a methods of using the particular binder polymer described above is useful; addition of a hydrophilic compound is useful for improvement in the developing speed in the unexposed area, while addition of a hydrophobic compound is useful for control of penetration of the developing solution into the exposed area.

### [Exposure]

The light source for use in the exposure of the invention is not particularly limited if it emits a light at a wavelength of 750 to 1,400 nm, however an infrared laser is preferable. Among infrared lasers, a solid-state or semiconductor laser emitting an infrared light at a wavelength of 750 to 1,400 nm is preferable for image exposure in the invention. The laser output is preferably 100 mW or more, and use of a multi-beam laser device is preferable for shortening the exposure period. The exposure period per pixel is preferably 20 µseconds or less. The energy of the light irradiated onto the planographic printing plate precursor is preferably 10 to 300 mJ/cm². An excessively low light-exposure energy prohibits sufficient hardening of the photosensitive layer. Alternatively, an excessively high light-exposure energy may result in laser ablation of the photosensitive layer and thus in damage of the image.

Multiple light beams from a light source may be irradiated overlapped in the exposure step according to the invention. The overlapping irradiation means that the secondary scanning pitch width is smaller than the beam width. When the beam width is expressed by a half-value width of beam intensity (FWHM), the overlap can be expressed quantitatively, for example, by an overlapping coefficient, i.e., FWHM/secondary scanning pitch width. The overlapping coefficient is preferably 0.1 or more in the invention.

The light-scanning method in the exposure device for use in the invention is not particularly limited, and the exposure may be performed either by scanning the external or internal wall of cylindrical printing plate precursor or the surface of flat printing plate precursor. The light source may be single-or multi-channeled, however the multi-channeled light source is preferably used in the mode of scanning the external surface of cylindrical precursor.

In the invention, as described above, the planographic printing plate precursor is preferably supplied after exposure to the development step without particular heat treatment or washing treatment. Absence of the heat treatment allows prevention of the nonuniformity of images caused by the heat treatment. In addition, absence of the heating and washing treatments enables steady development at high speed.

### [Development]

The non-image region in the image-recording layer is removed during development in the invention, by using a developing solution. In the invention, as described above, the processing speed during development, i.e., the traveling speed (line speed) of the planographic printing plate precursor during development, should be 1.25 m/min or more and more preferably 1.35 m/min or more. The upper limit of the traveling speed is not particularly limited, but preferably 3 m/min or less from the viewpoint of stability. In the invention, the protective layer removed during development contains organic resin fine particles and mica particles as described above, and the organic resin fine particles are dispersed preferably, and thus, the organic resin fine particles are also dispersed preferably in the developing solution after development. As a result, the developing solution for use in the invention is better in storage stability.

Hereinafter, the developing solution for use in the invention will be described.

### (Developing solution)

The developing solution for use in the invention is preferably an aqueous alkaline solution at a pH of 14 or less and contains an aromatic anionic surfactant.

### (Aromatic anionic surfactant)

The aromatic anionic surfactant for use in the developing solution according to the invention is effective in accelerating development and stabilizing dispersion of the components contained in the polymerizable negative image-recording layer and the protective layer in the developing solution, and thus, is preferable for stabilizing development. In particular, the aromatic anionic surfactant for use in the invention is preferably a compound represented by the following Formula (A) or (B).

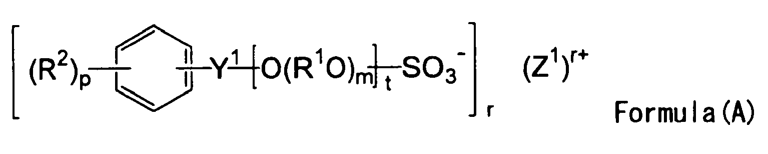

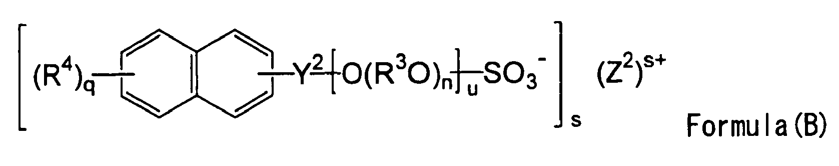

In Formula (A) or (B) above,
R¹ and R³ each represents a straight chain or branched chain alkylene group having 1 to 5 carbon atoms, specifically an ethylene, propylene, butylene, or pentylene group ; among them, ethylene and propylene groups are particularly preferable; m and n each represent an integer of 1 to 100, more preferably 1 to 30, and still more preferably 2 to 20. When m is 2 or more, the multiple R¹ groups may be the same as or different from each other. Alternatively, when n is 2 or more, the multiple R³ groups may be the same as or different from each other. t and u each independently represent 0 or 1.

R² and R⁴ each independently represent a straight chain or branched chain alkyl group having 1 to 20 carbons, specifically a methyl, ethyl, propyl, butyl, hexyl, or dodecyl group; and, among them, methyl, ethyl, iso-propyl, n-propyl, n-butyl, iso-butyl, and tert-butyl groups are particularly preferable.

Each of p and q denotes an integer of 0 to 2. Y¹ and Y² each represent a single bond or an alkylene group having 1 to 10 carbon atoms; specifically, a single bond and methylene and ethylene groups are preferable; and a single bond is particularly preferable.

(Z¹)^{r+} and (Z²)^{s+} each represent an alkali metal ion, an alkali-earth metal ion, or an unsubstituted or alkyl-substituted ammonium ion; and specific examples thereof include lithium, sodium, potassium, magnesium, calcium, and ammonium ions, secondary to quaternary ammonium ions substituted with an alkyl group, an aryl groups or an aralkyl group having 1 to 20 carbons; and a sodium ion is particularly preferable. Each of r and s is 1 or 2.

Hereinafter, specific examples thereof are listed, however the invention is not restricted thereby.

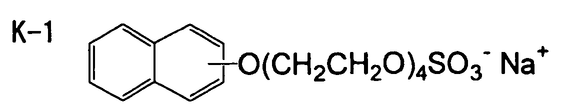

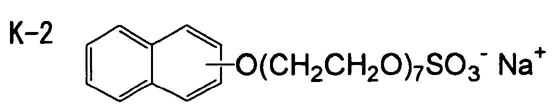

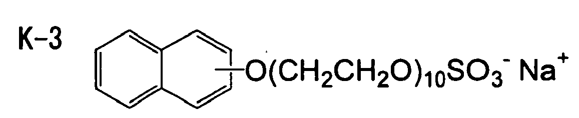

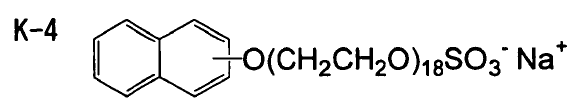

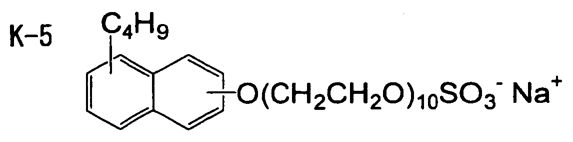

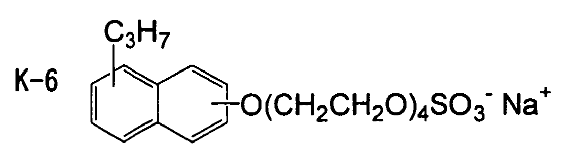

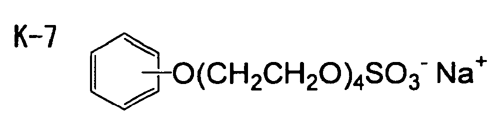

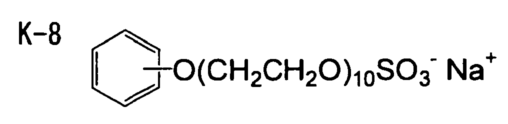

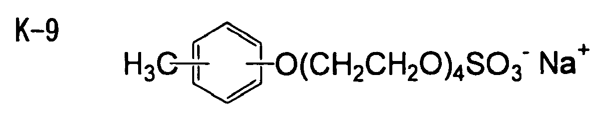

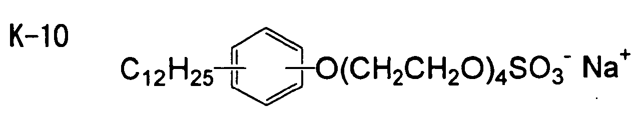

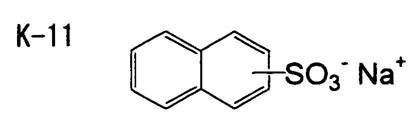

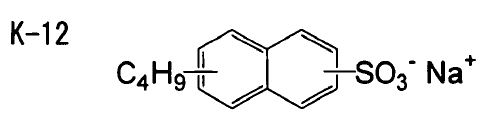

These aromatic anionic surfactants may be used alone or in combination of two or more as needed. The amount of the aromatic anionic surfactant added, i.e., the concentration of the aromatic anionic surfactant in the developing solution, is preferably in the range of 1.0 to 10% by mass and more preferably in the range of 2 to 10% by mass. A content of 1.0% by mass or less may lead to deterioration in printing efficiency and decrease in the solubility of photosensitive layer component, while a content of 10% by mass or more to decrease in the printing durability of printing plate.

In addition to the aromatic anionic surfactants above, other surfactants may be used in combination with the developing solution according to the invention. Examples of other surfactants include nonionic surfactants including polyoxyethylene alkylethers such as polyoxyethylene naphthylether, polyoxyethylene alkylphenylester, polyoxyethylene laurylether, polyoxyethylene cetylether, and polyoxyethylene stearylether; polyoxyethylene alkyl esters such as polyoxyethylene stearate; sorbitan alkyl esters such as sorbitan monolaurate, sorbitan monostearate, sorbitan distearate, sorbitan monooleate, sorbitan sesquioleate, and sorbitan trioleate; monoglyceride alkyl esters such as glycerol monostearate, and glycerol monooleate.

The content of these other surfactants in the developing solution is preferably 0.1 to 10% by mass as effective components.

### (Chelating agent for divalent metals)

The developing solution according to the invention preferably contains a chelating agent for divalent metals, for the purpose of eliminating the influence, for example, by the calcium ion contained in hard water. Examples of the chelating agents for divalent metals include poly phosphate salts such as Na₂P₂O₇ Na₅P₃O₃, Na₃P₃O₉, Na₂O₄P(NaO₃P)PO₃Na₂, and Calgon (polysodium metaphosphate); aminopolycarboxylic acids such as ethylenediamine tetraacetic acid, the potassium, sodium, and amine salts thereof; diethylenetriaminepentaacetic acid and the potassium and sodium salts thereof, triethylenetetraminehexaacetic acid and the potassium and sodium salts thereof, hydroxyethylethylenediaminetriacetic acid and the potassium and sodium salts thereof, and nitrilotriacetic acid and the potassium and sodium salts thereof, 1,2-diaminocyclohexane tetraacetic acid and the potassium and sodium salts thereof, and 1,3-diamino-2-propanol tetraacetic acid and the potassium and sodium salts thereof; and organic phosphonic acids such as 2-phosphonobutane tricarboxylic acid-1,2,4 and the potassium and sodium salts thereof, 2-phosphonobutanone tricarboxylic acid-2,3,4 and the potassium and sodium salts thereof, 1-phosphonoethane tricarboxylic acid-1,2,2 and the potassium and sodium salts thereof, 1-hydroxyethane-1,1-diphosphonic acid and the potassium and sodium salts thereof, and aminotri(methylenephosphonic acid) and the potassium and sodium salts thereof, and among them, ethylenediamine tetraacetic acid and the potassium, sodium, and amine salts thereof, ethylenediamine tetra(methylenephosphonic acid) and the ammonium and potassium salts thereof, and hexamethylenediamine tetra(methylenephosphonic acid) and the ammonium and potassium salts thereof are preferable. The most suitable content of the chelating agent may vary according to the hardness of the hard water used and the use amount, but is generally in the range of 0.01 to 5%, more preferably in the range of 0.01 to 0.5% by mass in the developing solution used.

The developing solution according to the invention may further contain an alkali metal salt of organic or inorganic acids as the development adjuster. Examples of the salts include sodium carbonate, potassium carbonate, ammonium carbonate, sodium citrate, potassium citrate, ammonium citrate, and these salts may be used alone or in combination of or two or more.

### (Alkali agents)

Examples of the alkali agents used in the developing solution according to the invention include inorganic alkali agents such as trisodium phosphate, tripotassium phosphate, triammonium phosphate, sodium borate, potassium borate, ammonium borate, sodium hydroxide, potassium hydroxide, ammonium hydroxide, and lithium hydroxide; and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. In the invention, these alkali agents may be used alone or in combination of two or more.

In addition to the alkali agent above, alkali silicate salts can be used. The alkali silicate salt may be used in combination with a base. The alkali silicate salt used is a salt that becomes alkaline when dissolved in water, and the examples thereof include sodium silicate, potassium silicate, lithium silicate, ammonium silicate . These alkali silicate salts may be used alone or in combination of two or more.

The developing solution for use in the invention can be adjusted into the most preferable range, by controlling the mixing ratio and the concentration of silicon oxide SiO₂, a component of the silicate salt used as the hydrophilizing component of support, and an alkali oxide M₂O (M represents an alkali metal or an ammonium group.) used as the alkali component. The mixing ratio of silicon oxide SiO₂ to alkali oxide M₂O (SiO₂/M₂O in molar ratio) is preferably in the range of 0.75 to 4.0, more preferably in the range of 0.75 to 3.5, for the purpose of suppressing the stains during storage caused by excessive dissolution (etching) of the anodic oxide film on support or the generation of insoluble gases caused by complex formation between the dissolved aluminum and the silicate salt.

In addition, the concentration of the alkali silicate salt in the developing solution is preferably in the range of 0.01 to 1 mol/L and more preferably in the range of 0.05 to 0.8 mol/L as SiO₂ with respect to the mass of the developing solution, from the viewpoints of suppression of the dissolution (etching) of the anodic oxide film on support, printing efficiency, suppression of precipitation and crystal growth, suppression of the gelation during neutralization of wastewater.

The developing solution used in the invention may further contain the following components as needed in addition to the components above. Examples of such additives include organic carboxylic acids such as benzoic acid, phthalic acid, p-ethylbenzoic acid, p-n-propylbenzoic acid, p-isopropylbenzoic acid, p-n-butylbenzoic acid, p-t-butylbenzoic acid, p-2-hydroxyethylbenzoic acid, decanoic acid, salicylic acid, and 3-hydroxy-2-naphthoic acid; organic solvents such as propylene glycol; as well as reducing agents, dyes, pigments, water softeners, antiseptics.

The developing solution for use in the invention preferably has a pH at 25°C in the range of 10 to 12.5 and more preferably in the range of 11 to 12.5. As the developing solution according to the invention contains the surfactant above, it provides an excellent printing efficiency in the non-image portion even in a developing solution at low pH. It is possible to reduce the damage on image portions during development and to make it easier to handle the developing solution, by lowering the pH of the developing solution to a relatively lower value in this manner.

The conductivity x of the developing solution is preferably 2 < x < 30 mS/cm and more preferably 5 to 25 mS/cm. Here, addition of an alkali metal salt of organic or inorganic acid as the conductivity adjuster is preferable, for adjusting the conductivity of the developing solution.

The developing solution may be used as the developing solution for exposed planographic printing plate precursors and replenishing developing solution, and is preferably used in automatic developing machines. When developed in an automatic developing machine, the developing solution becomes exhausted as processing continued, and thus may be reactivated by using a replenishing solution or new developing solution. In the plate-making method according to the invention, the replenishing method is preferably applied.

Use of the replenishing method described in U.S. Patent No. 4,882,246 is also preferable for recovering the processing efficiency of the developing solution in automatic developing machine. The developing solutions described in JP-A Nos. 50-26601 and 58-54341 and JP-B Nos. 56-39464, 56-42860, and 57-7427 are also preferable.

The replenishing developing solution more preferable in the invention is an aqueous solution containing an oxycarboxylate chelating agent capable of forming a water-soluble chelate with aluminum ion, an alkali metal hydroxide and a surfactant, but containing no silicate salt, at a pH of 11 to 13.5. Use of such a replenishing developing solution suppresses deterioration in its superior printing efficiency and the strength of the plate-material image region, prevents effectively precipitation of aluminum hydroxide, which is formed by elution of the aluminum support by the alkali in the developing solution, and reduces the deposition of stains mainly containing aluminum hydroxide as the primary component on the surface of the development-bath roller in automatic developing machine, and accumulation of the aluminum hydroxide deposit in the following water washing bath, and thus, stabilizes development for an extended period of time.

The planographic printing plate precursor thus developed is processed additionally with washing water, a rinsing solution containing a surfactant and others, and a desensitizing solution containing gum arabic or a starch derivative, as described in JP-A Nos. 54-8002, 55-115045, and 59-58431. These treatments may be used in combination for post-treatment of the planographic printing plate precursor according to the invention. The planographic printing plate after such treatments is then send to an offset printing machine, in which it is used for printing on numerous papers.

In the platemaking method of the planographic printing plate according to the invention, image strength, the entire surface of the image after development may additionally be heated or exposed to light for improvement in the strength and printing durability of image region.

A considerably severe condition may be used during the heating after development. It is normally performed at a heating temperature in the range of 200 to 500°C. A lower heating temperature after development may lead to deterioration in image strength, while an excessively higher temperature causes the problems of degradation of the support and thermal decomposition of the image region.

The planographic printing plate after such treatments is then send to an offset printing machine, in which it is used for printing on numerous papers.

Any one of the plate cleaners for PS plates known in the art may be used as the plate cleaner for removal of dirt and stains on printing plates during printing. The plate cleaners include Multicleaners CL-1, CL-2, CP, CN-4, CN, CG-1, PC-1, SR, and IC (manufactured by Fuji Photo Film Co. Ltd.).

### EXAMPLES

Hereinafter, the invention will be described with reference to Examples, however it should be understood that the invention is not restricted by these Examples.

### (Preparation of aqueous dispersion of organic resin fine particles)

### [Aqueous dispersion of MX-500]

3.0 g of a nonionic surfactant Emalex 710 manufactured by Nippon Nyukazai Co., Ltd. was added to and dissolved in 77 g of purified water. 20.0 g of crosslinked acrylic resin fine particles MX-500 manufactured by Soken Chemical & Engineering Co., Ltd. were added to the aqueous solution, and the mixture was dispersed in Ace homogenizer manufactured by Nippon Seiki Co., Ltd. at 10,000 rpm for 3 minutes, to give an aqueous MX-500 dispersion.

### [Aqueous MBP-8 dispersion]

An aqueous MBP-8 dispersion was prepared in a similar manner to the aqueous MX-500 dispersion, except that MX-500 in the aqueous MX-500 dispersion was replaced with 20.0 g of hollow acrylic resin fine particles MBP-8 manufactured by Sekisui Plastics Co., Ltd.

### (Example 1)

### (Preparation of support)

A JIS-A-1050 aluminum plate having a thickness of 0.30 mm and a width of 1,030 mm was surface-treated in the following manner:

### <Surface treatment>

The following various treatments (a) to (f) were performed continuously. The processing solution remaining on the aluminum plate was removed by nip roller after washing with water after each treatment.
(a) The aluminum plate was etched in an etching solution containing sodium hydroxide at a concentration of 26 mass% and aluminum ion at a concentration of 6.5 mass%, at a temperature of 70°C, allowing solubilization of the aluminum plate to an amount of 5 g/m². The aluminum plate was then washed with water.
(b) The aluminum plate was then desmutted by spraying aqueous 1 mass% nitric acid solution (containing 0.5 mass% aluminum ion) at a temperature of 30°C, and then washed with water.
(c) The aluminum plate was then surface-roughened electrochemically continuously by applying an AC voltage of 60 Hz. The electrolytic solution then was aqueous 1 mass% nitric acid solution (containing 0.5 mass% aluminum ion and 0.007 mass% ammonium ion) at a temperature of 30°C. The electrochemical surface-roughening treatment was conducted by using an alternate-current power source having a time required for the electric current to increase from zero to peak (TP) of 2 msec, a duty ratio of 1:1, and a trapezoidal waveform; and a carbon electrode was used as the reference electrode. A ferrite electrode was used as the auxiliary anode. The electric current density was 25 A/dm² at the peak of electric current, and the total amount of electricity used for this treatment was 250 C/cm² when the aluminum plate was an anode. Part (5%) of the electricity from the power source was diverted to the auxiliary electrode. The aluminum plate was then washed with water.
(d) The aluminum plate was etched by spraying a solution containing sodium hydroxide at a concentration 26% by mass and aluminum ion at a concentration of 6.5% by mass at 35°C, until aluminum was dissolved to an amount of 0.2 g/m², and subsequently, the smuts mainly consisting of aluminum hydroxide generated during the electrochemical surface roughening by using the alternate current above were removed, and the edge areas of the pit generated were dissolved and smoothened. The aluminum plate was then washed with water.
(e) The aluminum plate was subjected to a desmut treatment of spraying an aqueous 25% by mass sulfuric acid solution (containing aluminum ion at a concentration 0.5% by mass) at a temperature of 60°C and the washed with water by spraying.
(f) The aluminum plate was subjected to an anodizing treatment in an electrolyte containing sulfuric acid at a concentration 170 g/L (additionally containing aluminum ion at a concentration 0.5% by mass) at a temperature of 33°C and an electric current density of 5 (A/dm²) for 50 seconds. The aluminum plate was then washed with water. The mass of the anodic oxide film then was 2.7 g/m².

The surface roughness Ra of the aluminum support thus obtained was 0.27 (analyzer; Furfcom, manufactured by Tokyo Seimitsu Co. Ltd., diameter of the probe tip: 2 µm).

### (Undercoat layer)

Then, the following undercoat layer-coating solution was applied on the aluminum support with a wire bar and dried at 90°C for 30 seconds. The coating amount was 10 mg/m².

### <Undercoat layer-coating solution>

- Polymer compound A in the following structure 0.05 g
- Methanol 27 g
- Ion-exchange water 3 g

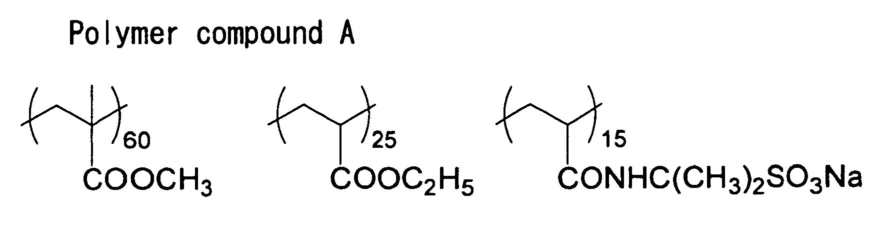

### (Photosensitive layer)

Then, the following photosensitive layer-coating solution [P-1] was prepared, and coated on the undercoat layer surface of the aluminum support with a wire bar. The coated layer was dried in a hot air dryer at 115°C for 34 seconds, to form a photosensitive layer. The coating amount after drying was 1.4 g/m².

### <Photosensitive layer-coating solution [P-1]>

- Infrared absorbent (IR-1) 0.074 g
- Polymerization initiator (OS-12) 0.280 g
- Additive (PM-1) 0.151 g
- Polymerizable compound (AM-1) 1.00 g
- Binder polymer (BT-1) 1.00 g
- Ethyl violet (C-1) 0.04 g
- Fluorochemical surfactant 0.015 g
   (Magafac F-780-F, manufactured by Dainippon Ink and Chemicals, Inc. Co., Ltd., methylisobutylketone (MIBK) 30 mass% solution)

- Methylethylketone 10.4 g
- Methanol 4.83 g
- 1-Methoxy-2-propanol 10.4 g

The polymerization initiator (OS-12) used in the photosensitive layer-coating solution was an onium salt represented by Formula (1) above. The structures of infrared absorbent (IR-1), additive (PM-1), polymerizable compound (AM-1), binder polymer (BT-1), and ethyl violet (C-1) are shown below.

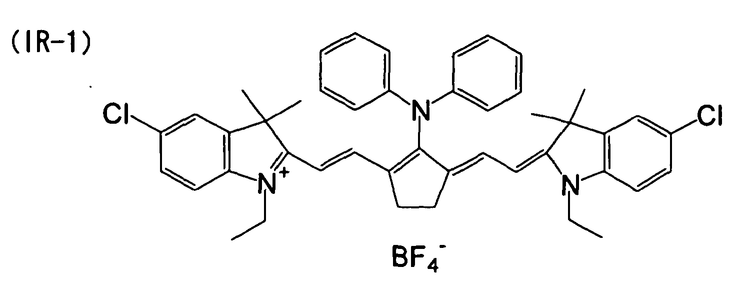

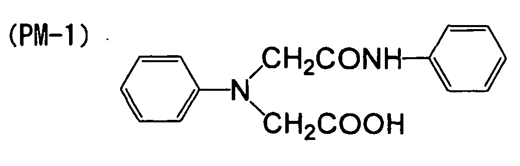

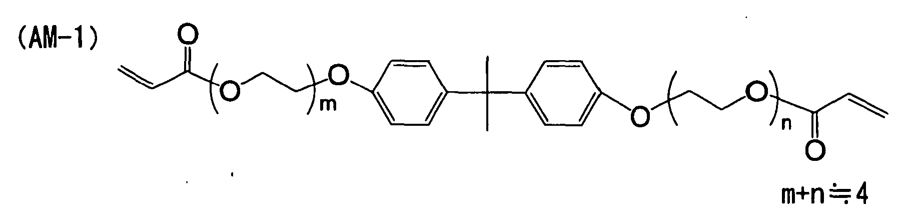

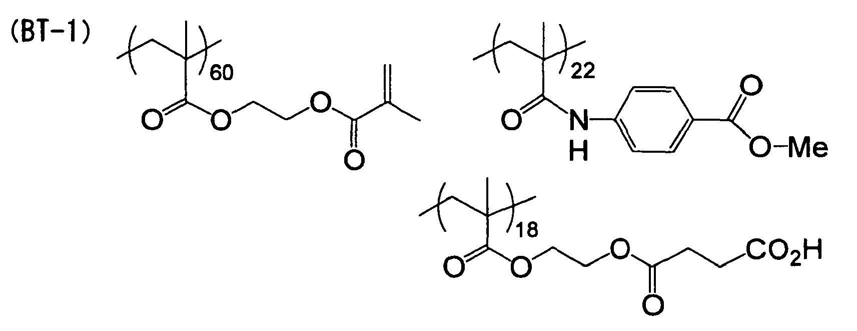

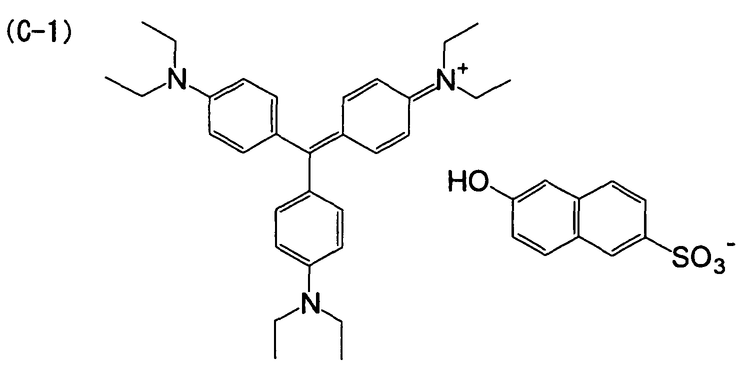

### (Protective layer)

An aqueous mixed solution (protective layer-coating solution) containing:
- organic resin fine particles (Chemipearl W308, 40 mass% aqueous dispersion, manufactured by Mitsui Chemicals, Inc.) 12.5 g,
- synthetic mica (Somasif ME-100, 8 mass% aqueous dispersion, manufactured by CO-OP Chemical Co., Ltd.) 94 g,
- polyvinylalcohol 82 g
   (CKS-50: saponification degree 99 mol%, polymerization degree: 300, sulfonic acid-modified, manufactured by Nippon Synthetic Chemical Industry Co., Ltd.),
- water-soluble poly(meth)acrylic ester (above polymer compound A) 5 g,
- surfactant-1 5 g
   (Emalex 710, manufactured by Nihon-Emulsion Co., Ltd.), and
- purified water 1,980 g
   was applied on the photosensitive layer surface above with a wire bar and dried in a hot air dryer at 125°C for 75 seconds.

The total coating amount of the protective layer (after drying) was 1.6 g/m². Thus, a planographic printing plate precursor of Example 1 was prepared.

### [Examples 2 to 5]

Planographic printing plate precursors of Examples 2 to 5 were prepared in a similar manner to Example 1, except that the kind of the organic resin fine particles and the addition amount of the mica particles in the composition of the protective layer-coating solution of Example 1 were changed to those shown in the following Table 1.

### [Comparative Example 1]

A planographic printing plate precursor of Comparative Example 1 was prepared in a similar manner to Example 1, except that the organic resin fine particles in the composition of the protective layer-coating solution of Example 1 were eliminated.

### [Comparative Example 2]

A planographic printing plate precursor of Comparative Example 2 was prepared in a similar manner to Example 3, except that the synthetic mica Somasif ME-100 in the composition of the protective layer-coating solution of Example 3 was eliminated.

### [Evaluation]

### (1) Evaluation of the dispersion stability of organic resin fine particles

70 g of the protective layer-coating solution after preparation was placed in a transparent glass bottle having a diameter of 3.0 mm and a height of 120 mm, and the bottle was left indoor at 25°C for 2 days. The protective layer-coating solution was observed visually after two days, and if there was white powder of the organic resin fine particles separated on the bottom of the container or on the liquid surface, the dispersion stability was rated G2, and if there is no separation, it was rated G1.

### (2) Evaluation of sensitivity

The planographic printing plate precursor obtained was exposed to light under the condition of a resolution of 2,400 dpi (94.5 dot/mm), a peripheral drum rotational frequency of 200 rpm, and an output changing in the range of 0 to 8 W at an interval of 0.15 as log E, by using Trendsetter 800II Quantum manufactured by Creo. The plate precursor was exposed to light under a condition of 25°C and 50% RH. After exposure, without heat treatment nor water washing, it was developed in an automatic developing machine LP-1310 HII manufactured by Fuji Photo Film Co., Ltd. at a traveling speed (line speed) of 2 m/minute and a developing temperature of 30°C. The developing solution used was an aqueous 1:4 diluted solution of DH-N, and the replenishing developing solution used, an aqueous 1:1.4 diluted solution of FCT-421; and the finisher, an aqueous 1:1 diluted solution of GN-2K manufactured by Fuji Photo Film Co., Ltd.

The density of the image area developed on the planographic printing plate was determined by using Macbeth reflection densitometer RD-918, based on the cyan density obtained by using the red filter, an accessory of the densitometer. A reciprocal number of the exposure intensity needed for giving a measured density of 0.9 was determined as an indicator of the sensitivity. Evaluation results of the planographic printing plates are relative values, compared to 100 of the sensitivity of the planographic printing plate obtained in EXAMPLE 1. A larger value indicates a higher sensitivity.

### (3) Evaluation of abrasion resistance

First, the planographic printing plate precursor thus obtained was placed in a cassette. Twenty sheets of the planographic printing plate precursor obtained were laminated without insert paper, forming a stack. The stack of planographic printing plates were placed on the planographic printing plate precursor previously stored in the cassette as it was deviated by 5 cm from the edge (20 stacked plate precursors sticking out of the edge of the plate precursor in the cassette by 5 cm), and the edge of the 20 plate materials sticking out was pushed in the horizontal direction in such a manner that the rear surface of the aluminum support at the bottom of the 20 stacked plates abraded the protective layer surface of the top plate precursor in the cassette. The plate precursor having the protective layer surface abraded by the rear surface of aluminum support rear surface was used for evaluation of the abrasion resistance of plate material.

The plate precursor was fed from the original region into Trendsetter 3244 manufactured by Creo by an autoloader, and a 50% screen tint image at a resolution of 2,400 dpi was formed thereon by photoirradiation at an output of 7W, an external-drum rotation speed of 150 rpm, and a plate surface energy of 110 mJ/cm². After photoirradiation, the plate was developed similarly to that used in evaluation of sensitivity. Scratches in the screen tint image on the planographic printing plate obtained were evaluated by visual observation. Visual evaluation results are grouped into ranks 1 to 5, and rank 3 was at the lowest practical level, and rank 2 or less was at a level practically unusable.

### (4) Evaluation of adhesion resistance

Three planographic printing plate precursors obtained (10x10 cm) were conditioned in an environment at 25°C and 75% RH, and the three precursors were stacked in the same direction without using insert paper, to give a stack. The stack was sealed with alminum kraft paper tightly, and the package was left under a load of 4 kg at 30°C for 5 days. Then, the adhesion between the photosensitive layer-sided surface (protective layer surface) of a planographic printing plate precursor and the support-sided surface of the adjacent planographic printing plate precursor was evaluated. The results of the adhesion test between planographic printing plate precursors as determined by visual evaluation were grouped into five ranks, and rank 3 indicates a practical lower limit level, and rank 2 or less, a practically unusable level. The results are summarized in Table 1.

**Table 1**

| | Protective layer | | | | | | Evaluation results | | | |
|---|---|---|---|---|---|---|---|---|---|---|
| | Organic resin fine particles | | | | Mica particles | | Dispersion stability of organic resin fine particles | Sensitivity | Abrasion resistance | Adhesion resistance |
| | Kind | Particle diameter (µm) | Absolute specific gravity | Solid content addition amount | Kind | Solid content addition amount | | | | |
| Example 1 | Chemipearl W308 | 6 | 0.97 | 5 g | Somasif ME-100 | 3.0 g | G l | 100 | 5 | 5 |
| Example 2 | Chemipearl W310 | 9.5 | 0.97 | 5 g | Somasif ME-100 | 3.0 g | G1 | 100 | 5 | 5 |
| Example 3 | Chemipearl W200 | 6 | 0.92 | 5 g | Somasif ME-100 | 3.0 g | G1 | 100 | 5 | 5 |
| Example 4 | MX-500 | 6 | 1.19 | 5 g | Somasif ME-100 | 3.0 g | G1 | 100 | 5 | 5 |
| Example 5 | MBP-8 | 8 | 1.1 | 5 g | Somasif ME-100 | 3.0 g | G1 | 100 | 5 | 5 |
| Comparative Example 1 | None | - | - | 0 g | Somasif ME-100 | 3.0 g | - | 120 | 2 | 1 |
| Comparative Example 2 | Chemipearl W200 | 6 | 0.92 | 5 g | None | - | G2 | 100 | 2 | 1 |

As apparent from Table 1, the planographic printing plate precursor of Examples 1 to 5, i.e., planographic printing plate precursors having a protective layer containing mica particles, organic resin fine particles and polyvinylalcohol formed on a polymerizable negative photosensitive layer, were superior in sensitivity and abrasion resistance without insert paper, and the planographic printing plate precursors did not adhere to each other even after storage under high-humidity condition. In addition, the protective layer-coating solutions for the planographic printing plate precursors of Examples 1 to 5 were superior in stability during production, and did not permit separation of the organic resin fine particles over the coating solution surface or on the bottom of the container even when stored for two days before coating. Even when the coating solution was applied after storage for two days, the fine particles on the protective layer surface are uniformly distributed, and there is no coating irregularity.

In contrast, although the planographic printing plate precursor of Comparative Example 1 containing no organic resin fine particles were superior in sensitivity, the planographic printing plate precursors adhered to each other after storage in high-humidity environment and were significantly lower in abrasion resistance when the aluminum support rear surface and the protective layer surface are rubbed with each other. Similarly, the planographic printing plate precursor of Comparative Example 2 containing no mica particles caused separation of organic resin fine particles in the phase of protective layer-coating solution, and gave regions having no organic resin fine particles on the surface of the plate precursor protective layer after application, causing adhesion between plate precursors.

## Claims

1. A polymerizable negative planographic printing plate precursor comprising a hydrophilic support, and a polymerizable negative photosensitive layer and a protective layer containing polyvinylalcohol, organic resin fine particles having an average particle diameter in a range of 2.0 to 15 µm and mica particles as a top layer formed in this order on the hydrophilic support.

2. The polymerizable negative planographic printing plate precursor of Claim 1, wherein the specific gravity of the organic resin fine particles is in the range of 0.90 to 1.25.

3. The polymerizable negative planographic printing plate precursor of Claim 1, wherein the organic resin fine particles comprise an acrylic or polyolefin resin having a specific gravity of 0.90 to 1.01.

4. The polymerizable negative planographic printing plate precursor of Claim 1, wherein the content of the organic resin fine particles is 1.0 to 20 mass% with respect to the solid content in the protective layer.

5. The polymerizable negative planographic printing plate precursor of Claim 1, wherein the mica particles comprise a fluorine-based swelling mica.

6. The polymerizable negative planographic printing plate precursor of Claim 5, wherein the swelling mica has a thickness of 1 to 50 nm and a length of 1 to 20 nm.

7. The polymerizable negative planographic printing plate precursor of Claim 1, wherein the mass ratio of the organic resin fine particles to the mica particles is in the range of 3:1 to 2:3.

8. The polymerizable negative planographic printing plate precursor of Claim 1, wherein the polyvinylalcohol has a saponification degree of 91 to 99 mole%.

9. The polymerizable negative planographic printing plate precursor of Claim 1, wherein the photosensitive layer contains an infrared absorbent, a polymerization initiator, a polymerizable compound, and a binder polymer.

10. The polymerizable negative planographic printing plate precursor of Claim 9, wherein the infrared absorbent is a cyanine colorant.

11. The polymerizable negative planographic printing plate precursor of Claim 9, wherein the polymerization initiator is an onium salt.

12. The polymerizable negative planographic printing plate precursor of Claim 9, wherein the polymerizable compound is an addition-polymerization compound having an ethylenic unsaturated double bond.

13. The polymerizable negative planographic printing plate precursor of Claim 9, wherein the binder polymer is a binder polymer represented by the following Formula (i): 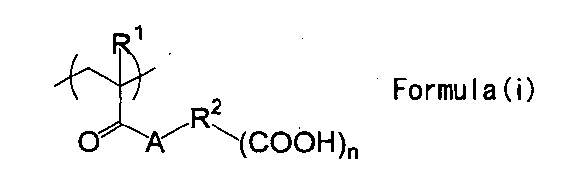 wherein, in Formula (i), R¹ represents a hydrogen atom or a methyl group; R² represents a connecting group containing two or more atoms selected from the group consisting of carbon, hydrogen, oxygen, nitrogen, and sulfur and having a total number of atoms of 2 to 82; A represents an oxygen atom or -NR³-; R³ represents a hydrogen atom or a monovalent hydrocarbon group having 1 to 10 carbon atoms; and n denotes an integer of from 1 to 5.

14. A stack of a plurality of the polymerizable negative planographic printing plate precursors according to any one of claims 1 to 13, wherein the plurality of the planographic printing plate precursors are stacked in such a manner that the protective layer of one precursor and the rear surface of the support of an adjacent precursor are in contact with each other.

15. A method of producing the polymerizable negative planographic printing plate precursor of Claim 1, comprising applying an aqueous solution containing polyvinylalcohol, organic resin fine particles having an average particle diameter in a range of 2.0 to 15 µm, and mica particles on a polymerizable negative photosensitive layer.

## Patentansprüche

1. Polymerisierbarer negativer planografischer Druckplattenvorläufer, umfassend einen hydrophilen Träger und eine polymerisierbare negative fotoempfindliche Schicht und eine Schutzschicht, die Polyvinylalkohol, feine organische Harzteilchen mit einem durchschnittlichen Teilchendurchmesser im Bereich von 2,0 bis 15 µm und Glimmerteilchen enthält, als Oberschicht, die in dieser Reihenfolge auf den hydrophilen Träger ausgebildet sind.

2. Polymerisierbarer negativer planografischer Druckplattenvorläufer gemäß Anspruch 1, worin die Dichte der feinen organischen Harzteilchen im Bereich von 0,90 bis 1,25 liegt.

3. Polymerisierbarer negativer planografischer Druckplattenvorläufer gemäß Anspruch 1, worin die feinen organischen Harzteilchen ein Acryl- oder Polyolefinharz mit einer Dichte von 0,90 bis 1,01 umfassen.

4. Polymerisierbarer negativer planografischer Druckplattenvorläufer gemäß Anspruch 1, worin der Gehalt an feinen organischen Harzteilchen 1,0 bis 20 Massen% in Bezug auf den Feststoffgehalt in der Schutzschicht beträgt.

5. Polymerisierbarer negativer planografischer Druckplattenvorläufer gemäß Anspruch 1, worin die Glimmerteilchen quellendes Glimmer auf Fluorbasis umfassen.

6. Polymerisierbarer negativer planografischer Druckplattenvorläufer gemäß Anspruch 5, worin der quellende Glimmer eine Dicke von 1 bis 50 nm und eine Länge von 1 bis 20 nm aufweist.

7. Polymerisierbarer negativer planografischer Druckplattenvorläufer gemäß Anspruch 1, worin das Massenverhältnis der feinen organischen Harzteilchen zu den Glimmerteilchen im Beriech von 3:1 bis 2:3 liegt.

8. Polymerisierbarer negativer planografischer Druckplattenvorläufer gemäß Anspruch 1, worin der Polyvinylalkohol einen Verseifungsgrad von 91 bis 99 Mol% aufweist.

9. Polymerisierbarer negativer planografischer Druckplattenvorläufer gemäß Anspruch 1, worin die fotoempfindliche Schicht ein Infrarotabsorptionsmittel, einen Polymerisationsinitiator, eine polymerisierbare Verbindung und ein Bindemittelpolymer enthält.

10. Polymerisierbarer negativer planografischer Druckplattenvorläufer gemäß Anspruch 9, worin der Polymerisationsinitiator ein Oniumsalz ist.

11. Polymerisierbarer negativer planografischer Druckplattenvorläufer gemäß Anspruch 9, worin der Polymerisationsinitiator ein Oniumsalz ist.

12. Polymerisierbarer negativer planografischer Druckplattenvorläufer gemäß Anspruch 9, worin die polymerisierbare Verbindung eine Additionspolymerisationsverbindung mit einer ethylenisch ungesättigten Doppelbindung ist.

13. Polymerisierbarer negativer planografischer Druckplattenvorläufer gemäß Anspruch 9, worin das Bindemittelpolymer ein Bindemittelpolymer ist, das durch die folgende Formel (i) dargestellt wird: 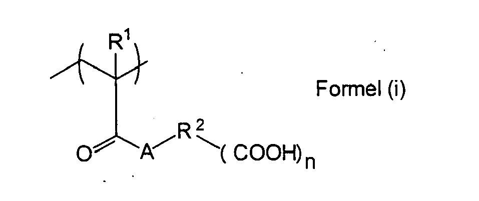 worin in Formel (i) R¹ ein Wasserstoffatom oder eine Methylgruppe darstellt, R² eine Verknüpfungsgruppe darstellt, die zwei oder mehrere Atome enthält, die aus der Gruppe ausgewählt werden, die aus Kohlenstoff, Wasserstoff, Sauerstoff, Stickstoff und Schwefel besteht, und eine Gesamtatomzahl von 2 bis 82 aufweist, A ein Sauerstoffatom oder -NR³- darstellt, R³ ei Wasserstoffatom oder eine einwertige Kohlenwasserstoffgruppe mit 1 bis 10 Kohlenstoffatomen darstellt und n eine ganze Zahl von 1 bis 5 darstellt.

14. Stapel aus einer Vielzahl von polymerisierbaren negativen planografischen Druckplattenvorläufern gemäß mindestens einem der Ansprüche 1 bis 13, worin die Vielzahl der planografischen Druckplattenvorläufer so gestapelt ist, dass die Schutzschicht eines Vorläufers und die Rückfläche des Trägers eines benachbarten Vorläufers in Kontakt miteinander sind.

15. Verfahren zur Herstellung des polymerisierbaren negativen planografischen Druckplattenvorläufers gemäß Anspruch 1, umfassend das Auftragen einer wässrigen Lösung, die Polyvinylalkohol, feine organische Harzteilchen mit einem durchschnittlichen Teilchendurchmesser von 2,0 bis 15 µm und Glimmerteilchen enthält, auf einer polymerisierbaren negativen fotoempfindlichen Schicht.

## Revendications

1. Précurseur de plaque d'impression planographique négative polymérisable comprenant un support hydrophile, et une couche photosensible négative polymérisable et une couche de protection contenant un poly(alcool vinylique), des particules fines de résine organique ayant un diamètre moyen de particules dans une plage de 2,0 à 15 µm et des particules de mica comme une couche supérieure formées dans cet ordre sur le support hydrophile.

2. Précurseur de plaque d'impression planographique négative polymérisable selon la revendication 1, dans lequel la densité des particules fines de résine organique est dans la plage de 0,90 à 1,25.

3. Précurseur de plaque d'impression planographique négative polymérisable selon la revendication 1, dans lequel les particules fines de résine organique comprennent une résine acrylique ou polyoléfinique ayant une densité de 0,90 à 1,01.

4. Précurseur de plaque d'impression planographique négative polymérisable selon la revendication 1, dans lequel la teneur des particules fines de résine organique est 1,0 à 20% en masse par rapport à la teneur en solides dans la couche de protection.

5. Précurseur de plaque d'impression planographique négative polymérisable selon la revendication 1, dans lequel les particules de mica comprennent un mica gonflant à base de fluor.

6. Précurseur de plaque d'impression planographique négative polymérisable selon la revendication 5, dans lequel le mica gonflant a une épaisseur de 1 à 50 nm et une longueur de 1 à 20 nm.

7. Précurseur de plaque d'impression planographique négative polymérisable selon la revendication 1, dans lequel le rapport en masse des particules fines de résine organique sur les particules de mica est dans la plage de 3:1 à 2:3.

8. Précurseur de plaque d'impression planographique négative polymérisable selon la revendication 1, dans lequel le poly(alcool vinylique) a un degré de saponification de 91 à 99% en moles.

9. Précurseur de plaque d'impression planographique négative polymérisable selon la revendication 1, dans lequel la couche photosensible contient un absorbant des infrarouges, un initiateur de polymérisation, un composé polymérisable, et un polymère de liaison.

10. Précurseur de plaque d'impression planographique négative polymérisable selon la revendication 9, dans lequel l'absorbant des infrarouges est une matière colorante à base de cyanine.

11. Précurseur de plaque d'impression planographique négative polymérisable selon la revendication 9, dans lequel l'initiateur de polymérisation est un sel onium.

12. Précurseur de plaque d'impression planographique négative polymérisable selon la revendication 9, dans lequel le composé polymérisable est un composé de polymérisation par addition ayant une liaison double insaturée éthylénique.

13. Précurseur de plaque d'impression planographique négative polymérisable selon la revendication 9, dans lequel le polymère de liaison est un polymère de liaison représenté par la Formule (i) suivante : 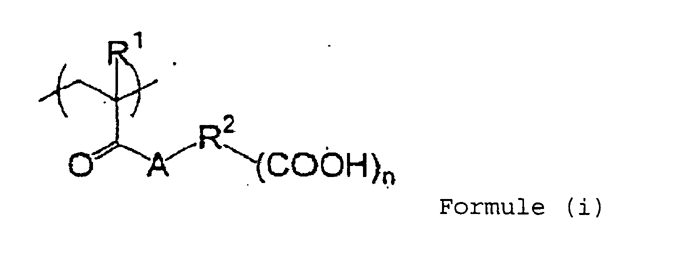 dans laquelle, dans la Formule (i), R¹ représente un atome d'hydrogène ou un groupe méthyle ; R² représente un groupe de connexion contenant deux atomes ou plus choisis parmi le groupe consistant en le carbone, l'hydrogène, l'oxygène, l'azote, et le soufre et ayant un nombre total d'atomes de 2 à 82 ; A représente un atome d'oxygène ou un -NR³- ; R³ représente un atome d'hydrogène ou un groupe hydrocarbure monovalent ayant 1 à 10 atomes de carbone ; et n dénote un entier de 1 à 5.

14. Empilement d'une pluralité des précurseurs de plaque d'impression planographique négative polymérisables selon l'une quelconque des revendications 1 à 13, dans lequel la pluralité des précurseurs de plaque d'impression planographique sont empilés de telle manière que la couche de protection d'un précurseur et la surface arrière du support d'un précurseur adjacent sont en contact l'une avec l'autre.

15. Procédé de production d'un précurseur de plaque d'impression planographique négative polymérisable selon la revendication 1, comprenant l'application d'une solution aqueuse contenant un poly(alcool vinylique), de particules fines de résine organique ayant un diamètre moyen de particules dans une plage de 2,0 à 15 µm et de particules de mica sur une couche photosensible négative polymérisable.
